# EUROPEAN PATENT APPLICATION

(11) **EP 4 181 167 A1**
(43) Date of publication of application: **17.05.2023**
(21) Application number: 21207845.5
(22) Date of filing: 11.11.2021
(51) Int. Cl.: H01J 37/02, H01J 37/28

(54) **CHARGED PARTICLE ASSESSMENT SYSTEM AND METHOD**

(71) Applicant: ASML Netherlands B.V., 5500 AH Veldhoven (NL)
(72) Inventor: WIELAND, Marco, Jan-Jaco, 5500 AH Veldhoven (NL); SLOT, Erwin, 5500 AH Veldhoven (NL)
(74) Representative: ASML Netherlands B.V.

(57) **Abstract**

The present invention provides a charged particle assessment system for projecting a beam of charged particles towards a sample. The system comprises a sample holder configured to hold a sample; a charged particle optical system configured to project a beam of charged particles from a charged particle source downbeam towards the sample and comprising a cleaning target; and a cleaning device. The cleaning device is configured to supply cleaning medium in a cleaning flow towards the cleaning target incident on the cleaning target so that the cleaning flow approaches the cleaning target from downbeam of the cleaning target, and to stimulate the cleaning medium at or near the cleaning target such that the cleaning medium cleans at least a portion of the surface of the cleaning target.

## Description

### FIELD

The embodiments provided herein generally relate to charged particle assessment systems and methods of operating charged particle assessment systems.

### BACKGROUND

When manufacturing semiconductor integrated circuit (IC) chips, undesired pattern defects, as a consequence of, for example, optical effects and incidental particles, inevitably occur on a substrate (i.e. wafer) or a mask during the fabrication processes, thereby reducing the yield. Monitoring the extent of the undesired pattern defects is therefore an important process in the manufacture of IC chips. More generally, the inspection and/or measurement of a surface of a substrate, or other object/material, is an important process during and/or after its manufacture.

Pattern inspection tools with a charged particle beam have been used to inspect objects, for example to detect pattern defects. These tools typically use electron microscopy techniques, using electron optical systems for example in a scanning electron microscope (SEM). In exemplary electron optical system such a SEM, a primary electron beam of electrons at a relatively high energy is targeted with a final deceleration step in order to land on a sample at a relatively low landing energy. The beam of electrons is focused as a probing spot on the sample. The interactions between the material structure at the probing spot and the landing electrons from the beam of electrons cause electrons to be emitted from the surface, such as secondary electrons, backscattered electrons or Auger electrons. The generated secondary electrons may be emitted from the material structure of the sample. By scanning the primary electron beam as the probing spot over the sample surface, secondary electrons can be emitted across the surface of the sample. By collecting these emitted secondary electrons from the sample surface, a pattern inspection tool may obtain an image representing characteristics of the material structure of the surface of the sample. The intensity of the electron beams comprising the backscattered electrons and the secondary electrons may vary based on the properties of the internal and external structures of the sample, and thereby may indicate whether the sample has defects.

Inspection tools can suffer from hydrocarbon contamination. This occurs when molecular carbon contamination grows on surfaces that are in a vacuum atmosphere with a high partial pressure of hydrocarbons in combination with exposure to electrons, a process known as electron beam induced deposition (EBID). One technique to limit the contamination on components of charged particle optical systems is differential pumping. However, there remains a problem that there is limited space in the inspection tool, and particularly between the charged particle optical system and the sample which may be coated with resist. Further the effectiveness of techniques such as differential pumping may be limited close to the sample. There is insufficient space available in typical design architectures of charged particle optical systems for a solution such as differential pumping to be used to limit, if not prevent, contamination on all components of the charged particle optical system which might be afflicted with contamination.

### SUMMARY

It is an object of the present disclosure to provide embodiments of charged particle assessment systems and methods of operating charged particle assessment systems.

According to a first aspect of the invention, there is provided a charged particle assessment system for projecting a beam of charged particles towards a sample. The system comprises a sample holder configured to hold a sample; a charged particle optical system configured to project a beam of charged particles from a charged particle source downbeam towards the sample and comprising a cleaning target; and a cleaning device. The cleaning device is configured to supply cleaning medium in a cleaning flow towards the cleaning target incident on the cleaning target so that the cleaning flow approaches the cleaning target from downbeam of the cleaning target, and to stimulate the cleaning medium at or near the cleaning target such that the cleaning medium cleans at least a portion of the surface of the cleaning target.

According to a second aspect of the invention, there is provided a method of operating a charged particle assessment system configured to project a beam of charged particles towards a sample. The charged particle assessment system comprises: a sample holder configured to hold a sample, and a charged particle optical system configured to project a beam of charged particles from a charged particle source downbeam towards the sample. The charged particle optical system comprises a cleaning target. The method comprises: supplying a cleaning medium in a cleaning flow towards the cleaning target incident on the cleaning target, the suppling of the cleaning flow such that cleaning flow approaches the cleaning target from downbeam of the cleaning target; and stimulating the cleaning medium at or near the cleaning target such that the cleaning medium cleans at least a portion of the surface of the cleaning target.

According to a third aspect of the invention, there is provided a charged particle assessment system for projecting a beam of charged particles towards a sample, the system comprising: a sample holder configured to hold a sample; a charged particle optical system configured to project a beam of charged particles from a charged particle source downbeam towards the sample, the charged particle optical system comprising a cleaning target; a cleaning arrangement comprising: a cleaning device to supply cleaning medium in a cleaning flow; a cleaning guide configured to guide and direct the cleaning flow from the cleaning device a towards the cleaning target so the cleaning flow is incident on the cleaning target so that cleaning flow approaches the cleaning target from down beam of the cleaning target, wherein the cleaning device is positioned in an up-beam direction relative to the sample holder and the cleaning guide comprises a flow deflector configured to deflect the cleaning flow towards the cleaning target.

### BRIEF DESCRIPTION OF FIGURES

The above and other aspects of the present disclosure will become more apparent from the description of exemplary embodiments, taken in conjunction with the accompanying drawings.
**FIG. 1** is a schematic diagram illustrating an exemplary electron beam inspection apparatus.
**FIG. 2** is a schematic diagram illustrating an exemplary multi-beam charged particle assessment system that is part of the exemplary electron beam inspection apparatus of **FIG. 1****.**
**FIG. 3** is a schematic diagram of an exemplary multi-beam charged particle assessment system according to an embodiment.
**FIG. 4** is a schematic diagram of an exemplary charged particle assessment system comprising a macro collimator and macro scan deflector.
**FIG. 5** is a schematic diagram of an exemplary multi-beam charged particle assessment system according to an embodiment.
**FIG. 6** is a schematic diagram of part of the multi-beam charged particle assessment system of **FIG. 5****.**
**FIG. 7** is a schematic cross-sectional view of an objective lens array of a charged particle assessment system according to an embodiment.
**FIG. 8** is a bottom view of a modification of the objective lens array of **FIG. 7****.**
**FIG. 9** is an enlarged schematic cross-sectional view of a detector incorporated in the objective lens array of **FIG. 7****.**
**FIG. 10** is a bottom view of a detector element of a detector.
**FIG. 11** is a schematic diagram of an exemplary charged particle assessment system comprising a cleaning device according to an embodiment.
**FIG. 12** is a schematic diagram of an exemplary charged particle assessment system comprising a cleaning device disposed on a stage according to an embodiment.
**FIG. 13** is a schematic diagram of an exemplary charged particle assessment system comprising a cleaning device and a cleaning guide according to an embodiment.
**FIG. 14** is a schematic diagram of an exemplary charged particle assessment system according to an embodiment wherein the charged particle source comprises the cleaning device.
**FIG. 15** is a schematic diagram of an exemplary charged particle assessment system comprising a cleaning device configured to supply a cleaning medium and to emit stimulating light according to an embodiment.
**FIG. 16A and FIG. 16B** is a schematic diagram of an exemplary charged particle assessment system comprising a cleaning device and light emitter according to an embodiment.

The schematic diagrams and views show the components described below. However, the components depicted in the figures are not to scale.

### DETAILED DESCRIPTION

Reference will now be made in detail to exemplary embodiments, examples of which are illustrated in the accompanying drawings. The following description refers to the accompanying drawings in which the same numbers in different drawings represent the same or similar elements unless otherwise represented. The implementations set forth in the following description of exemplary embodiments do not represent all implementations consistent with the invention. Instead, they are merely examples of apparatuses and methods consistent with aspects related to the invention as recited in the appended claims.

The enhanced computing power of electronic devices, which reduces the physical size of the devices, can be accomplished by significantly increasing the packing density of circuit components such as transistors, capacitors, diodes, etc. on an IC chip. This has been enabled by increased resolution enabling yet smaller structures to be made. For example, an IC chip of a smart phone, which is the size of a thumbnail and available in, or earlier than, 2019, may include over 2 billion transistors, the size of each transistor being less than 1/1000th of a human hair. Thus semiconductor IC manufacturing is a complex and time-consuming process, with many individual steps. An error in one of these steps has the potential to significantly influence the functioning of the final product. The goal of the manufacturing process is to improve the overall yield of the process. For example, to obtain a 75% yield for a 50-step process (where a step can indicate the number of layers formed on a wafer), each individual step must have a yield greater than 99.4%. If each individual step had a yield of 95%, the overall process yield would be as low as 7%.

While high process yield is desirable in an IC chip manufacturing facility, maintaining a high substrate (i.e. wafer) throughput, defined as the number of substrates processed per hour, is also essential. High process yield and high substrate throughput can be impacted by the presence of a defect. This is especially true if operator intervention is required for reviewing the defects. Thus, high throughput detection and identification of micro and nano-scale defects by inspection tools (such as a Scanning Electron Microscope ('SEM')) is essential for maintaining high yield and low cost.

A SEM comprises a scanning device and a detector apparatus. The scanning device comprises an illumination apparatus that comprises an electron source, for generating primary electrons, and a projection apparatus for scanning a sample, such as a substrate, with one or more focused beams of primary electrons. Together at least the illumination apparatus, or illumination system, and the projection apparatus, or projection system, may be referred to together as the electron-optical system or apparatus. The primary electrons interact with the sample and generate secondary electrons. The detection apparatus captures the secondary electrons from the sample as the sample is scanned so that the SEM can create an image of the scanned area of the sample. Such an inspection apparatus may utilize a single primary electron beam incident on a sample. For high throughput inspection, some of the inspection apparatuses use multiple focused beams, i.e. a multi-beam, of primary electrons. The component beams of the multi-beam may be referred to as sub-beams or beamlets. The sub-beams may be arranged with respect to each other within the multi-beam in a multi-beam arrangement. A multi-beam can scan different parts of a sample simultaneously. A multi-beam inspection apparatus can therefore inspect a sample at a much higher speed than a single-beam inspection apparatus.

An implementation of known multi-beam inspection apparatus is described below.

The figures are schematic. Relative dimensions of components in drawings are therefore exaggerated for clarity. Within the following description of drawings the same or like reference numbers refer to the same or like components or entities, and only the differences with respect to the individual embodiments are described. While the description and drawings are directed to an electron-optical system, it is appreciated that the embodiments are not used to limit the present disclosure to specific charged particles. References to electrons throughout the present document may therefore be more generally be considered to be references to charged particles, with the charged particles not necessarily being electrons.

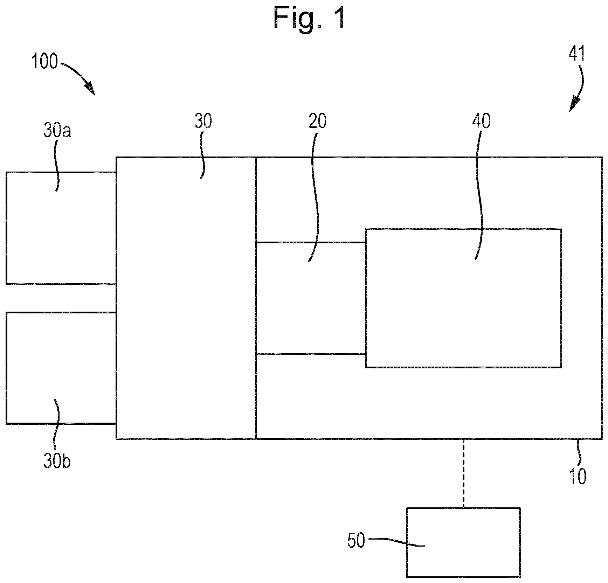

Reference is now made to **FIG. 1****,** which is a schematic diagram illustrating an exemplary charged particle beam inspection apparatus 100. The charged particle beam inspection apparatus 100 of **FIG. 1** includes a main chamber 10, a load lock chamber 20, a charged particle assessment system 40 (which may also be called an electron beam system or tool), an equipment front end module (EFEM) 30 and a controller 50. The charged particle assessment system 40 is located within the main chamber 10.

The EFEM 30 includes a first loading port 30a and a second loading port 30b. The EFEM 30 may include additional loading port(s). The first loading port 30a and the second loading port 30b may, for example, receive substrate front opening unified pods (FOUPs) that contain substrates (e.g., semiconductor substrates or substrates made of other material(s)) or samples to be inspected (substrates, wafers and samples are collectively referred to as "samples" hereafter). One or more robot arms (not shown) in the EFEM 30 transport the samples to the load lock chamber 20.

The load lock chamber 20 is used to remove the gas around a sample. This creates a vacuum that is a local gas pressure lower than the pressure in the surrounding environment. The load lock chamber 20 may be connected to a load lock vacuum pump system (not shown), which removes gas particles in the load lock chamber 20. The operation of the load lock vacuum pump system enables the load lock chamber to reach a first pressure below the atmospheric pressure. After reaching the first pressure, one or more robot arms (not shown) transport the sample from the load lock chamber 20 to the main chamber 10. The main chamber 10 is connected to a main chamber vacuum pump system (not shown). The main chamber vacuum pump system removes gas particles in the main chamber 10 so that the pressure in around the sample reaches a second pressure lower than the first pressure. After reaching the second pressure, the sample is transported to the charged particle assessment system 40 by which it may be inspected. The charged particle assessment system 40 comprises an electron-optical system 41. The term 'electron-optical device' may be synonymous with the electron-optical system 41. The electron-optical system 41 may be a multi-beam electron-optical system 41 configured to project a multi-beam towards the sample, for example the sub-beams being arranged with respect to each other in a multi-beam arrangement. Alternatively, the electron-optical system 41 may be a single beam electron-optical system 41 configured to project a single beam towards the sample.

The controller 50 is electronically connected to the charged particle assessment system 40. The controller 50 may be a processor (such as a computer) configured to control the charged particle beam inspection apparatus 100. The controller 50 may also include a processing circuitry configured to execute various signal and image processing functions. While the controller 50 is shown in **FIG. 1** as being outside of the structure that includes the main chamber 10, the load lock chamber 20, and the EFEM 30, it is appreciated that the controller 50 may be part of the structure. The controller 50 may be located in one of the component elements of the charged particle beam inspection apparatus or it can be distributed over at least two of the component elements. While the present disclosure provides examples of the main chamber 10 housing an electron beam inspection tool, it should be noted that aspects of the disclosure in their broadest sense are not limited to a chamber housing an electron beam inspection tool. Rather, it is appreciated that the foregoing principles may also be applied to other tools and other arrangements of apparatus, that operate under the second pressure.

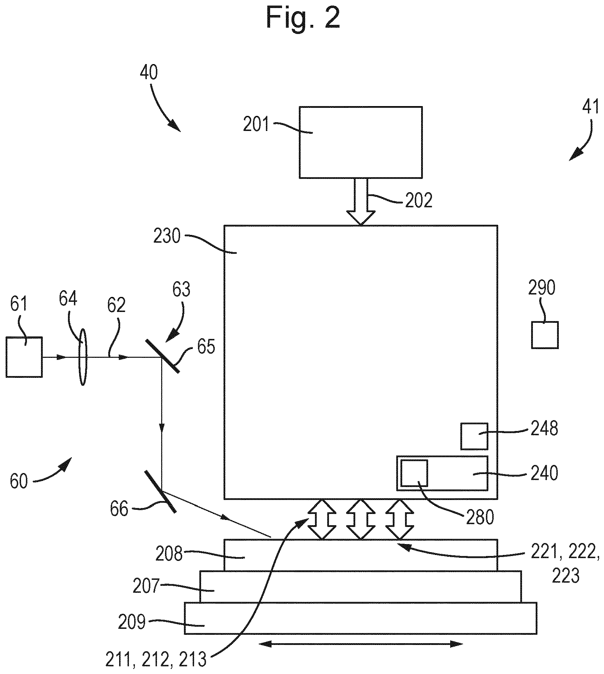

Reference is now made to **FIG. 2****,** which is a schematic diagram illustrating an exemplary charged particle assessment system 40 including a multi-beam electron-optical system 41 that is part of the exemplary charged particle beam inspection apparatus 100 of **FIG. 1****.** The multi-beam electron-optical system 41 comprises an electron source 201 and a projection apparatus 230. The charged particle assessment system 40 further comprises an actuated stage 209 and a sample holder 207. The sample holder may have a holding surface (not depicted) for supporting and holding the sample. Thus the sample holder may be configured to support the sample. Such a holding surface may be a electrostatic clamp operatable to hold the sample during operation of the electron optical system 41 e.g. assessment or inspection of the sample. The holding surface may be recessed into sample holder, for example a surface of the sample holder orientated to face the electron optical system 41. The electron source 201 and projection apparatus 230 may together be referred to as the electron-optical system 41. The sample holder 207 is supported by actuated stage 209 so as to hold a sample 208 (e.g., a substrate or a mask) for inspection. The multi-beam electron-optical system 41 further comprises a detector 240 (e.g. an electron detection device).

The electron source 201 may comprise a cathode (not shown) and an extractor or anode (not shown). During operation, the electron source 201 is configured to emit electrons as primary electrons from the cathode. The primary electrons are extracted or accelerated by the extractor and/or the anode to form a primary electron beam 202.

The projection apparatus 230 is configured to convert the primary electron beam 202 into a plurality of sub-beams 211, 212, 213 and to direct each sub-beam onto the sample 208. Although three sub-beams are illustrated for simplicity, there may be many tens, many hundreds or many thousands of sub-beams. The sub-beams may be referred to as beamlets.

The controller 50 may be connected to various parts of the charged particle beam inspection apparatus 100 of **FIG. 1****,** such as the electron source 201, the detector 240, the projection apparatus 230, and the actuated stage 209. The controller 50 may perform various image and signal processing functions. The controller 50 may also generate various control signals to govern operations of the charged particle beam inspection apparatus, including the charged particle multi-beam apparatus.

The projection apparatus 230 may be configured to focus sub-beams 211, 212, and 213 onto a sample 208 for inspection and may form three probe spots 221, 222, and 223 on the surface of sample 208. The projection apparatus 230 may be configured to deflect the primary sub-beams 211, 212, and 213 to scan the probe spots 221, 222, and 223 across individual scanning areas in a section of the surface of the sample 208. In response to incidence of the primary sub-beams 211, 212, and 213 on the probe spots 221, 222, and 223 on the sample 208, electrons are generated from the sample 208 which include secondary electrons and backscattered electrons. The secondary electrons typically have electron energy ≤ 50 eV. Actual secondary electrons can have an energy of less than 5 eV, but anything beneath 50 eV is generally treated at a secondary electron. Backscattered electrons typically have electron energy between 0 eV and the landing energy of the primary sub-beams 211, 212, and 213. As electrons detected with an energy of less than 50 eV is generally treated as a secondary electron, a proportion of the actual backscatter electrons will be counted as secondary electrons.

The detector 240 is configured to detect signal particles such as secondary electrons and/or backscattered electrons and to generate corresponding signals which are sent to a signal processing system 280, e.g. to construct images of the corresponding scanned areas of sample 208. The detector 240 may be incorporated into the projection apparatus 230.

The signal processing system 280 may comprise a circuit (not shown) configured to process signals from the detector 240 so as to form an image. The signal processing system 280 could otherwise be referred to as an image processing system. The signal processing system may be incorporated into a component of the multi-beam charged particle assessment system 40 such as the detector 240 (as shown in **FIG. 2**). However, the signal processing system 280 may be incorporated into any components of the inspection apparatus 100 or multi-beam charged particle assessment system 40, such as, as part of the projection apparatus 230 or the controller 50. The signal processing system 280 may include an image acquirer (not shown) and a storage device (not shown). For example, the signal processing system may comprise a processor, computer, server, mainframe host, terminals, personal computer, any kind of mobile computing devices, and the like, or a combination thereof. The image acquirer may comprise at least part of the processing function of the controller. Thus the image acquirer may comprise at least one or more processors. The image acquirer may be communicatively coupled to the detector 240 permitting signal communication, such as an electrical conductor, optical fiber cable, portable storage media, IR, Bluetooth, internet, wireless network, wireless radio, among others, or a combination thereof. The image acquirer may receive a signal from the detector 240, may process the data comprised in the signal and may construct an image therefrom. The image acquirer may thus acquire images of the sample 208. The image acquirer may also perform various post-processing functions, such as generating contours, superimposing indicators on an acquired image, and the like. The image acquirer may be configured to perform adjustments of brightness and contrast, etc. of acquired images. The storage may be a storage medium such as a hard disk, flash drive, cloud storage, random access memory (RAM), other types of computer readable memory, and the like. The storage may be coupled with the image acquirer and may be used for saving scanned raw image data as original images, and post-processed images.

The signal processing system 280 may include measurement circuitry (e.g., analog-to-digital converters) to obtain a distribution of the detected secondary electrons. The electron distribution data, collected during a detection time window, can be used in combination with corresponding scan path data of each of primary sub-beams 211, 212, and 213 incident on the sample surface, to reconstruct images of the sample structures under inspection. The reconstructed images can be used to reveal various features of the internal or external structures of the sample 208. The reconstructed images can thereby be used to reveal any defects that may exist in the sample.

The controller 50 may control the actuated stage 209 to move sample 208 during inspection of the sample 208. The controller 50 may enable the actuated stage 209 to move the sample 208 in a direction, preferably continuously, for example at a constant speed, at least during sample inspection. The controller 50 may control movement of the actuated stage 209 so that it changes the speed of the movement of the sample 208 dependent on various parameters. For example, the controller 50 may control the stage speed (including its direction) depending on the characteristics of the inspection steps of scanning process.

Known multi-beam systems, such as the charged particle assessment system 40 and charged particle beam inspection apparatus 100 described above, are disclosed in US2020118784, US20200203116, US 2019/0259570 and US2019/0259564 which are hereby incorporated by reference.

As shown in **FIG. 2****,** in an embodiment the charged particle assessment system 40 comprises a projection assembly 60. The projection assembly 60 may be a module and may be referred to as an ACC module. The projection assembly 60 is arranged to direct a light beam 62 such that the light beam 62 enters between the electron-optical system 41 and the sample 208.

When the electron beam scans the sample 208, charges may be accumulated on the sample 208 due to large beam current, which may affect the quality of the image. To regulate the accumulated charges on the sample, the projection assembly 60 may be employed to illuminate the light beam 62 on the sample 208, so as to control the accumulated charges due to effects such as photoconductivity, photoelectric, or thermal effects.

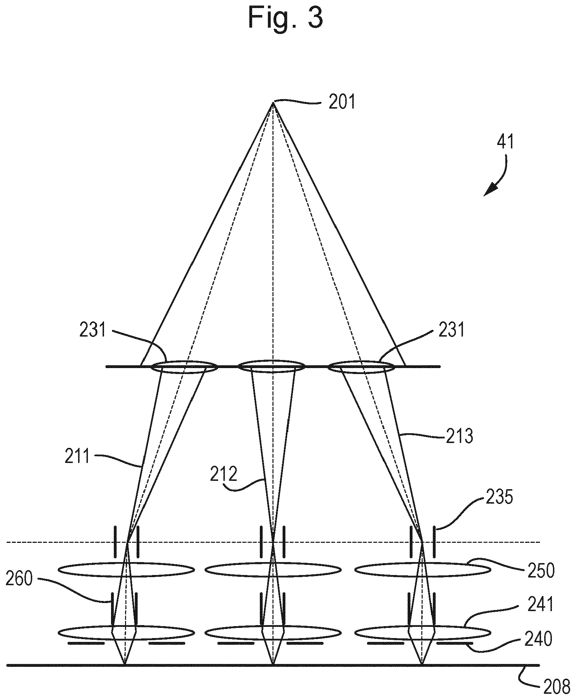

Components of a charged particle assessment system 40 which may be used in the present invention are described below in relation to **FIG. 3** which is a schematic diagram of a charged particle assessment system 40. The charged particle assessment system 40 of **FIG. 3** may correspond to the charged particle assessment system 40 (which may also be referred to as an apparatus or a tool) mentioned above.

The electron source 201 directs electrodes toward an array of condenser lenses 231 (otherwise referred to as a condenser lens array). The electron source 201 is desirably a high brightness thermal field emitter arranged to operate within an optimized electron-optical performance range that is a compromise between brightness and total emission current (such a compromise may be considered to be a 'good' compromise'). There may be many tens, many hundreds or many thousands of condenser lenses 231. The condenser lenses 231 may comprise multi-electrode lenses and have a construction based on EP1602121A1, which document is hereby incorporated by reference in particular to the disclosure of a lens array to split an e-beam into a plurality of sub-beams, with the array providing a lens for each sub-beam. The array of condenser lenses 231 may take the form of at least two plates, acting as electrodes, with an aperture in each plate aligned with each other and corresponding to the location of a sub-beam. At least two of the plates are maintained during operation at different potentials to achieve the desired lensing effect.

In an arrangement the array of condenser lenses 231 is formed of three plate arrays in which charged particles have the same energy as they enter and leave each lens, which arrangement may be referred to as an Einzel lens. Thus, dispersion only occurs within the Einzel lens itself (between entry and exit electrodes of the lens), thereby limiting off-axis chromatic aberrations. When the thickness of the condenser lenses is low, e.g. a few mm, such aberrations have a small or negligible effect.

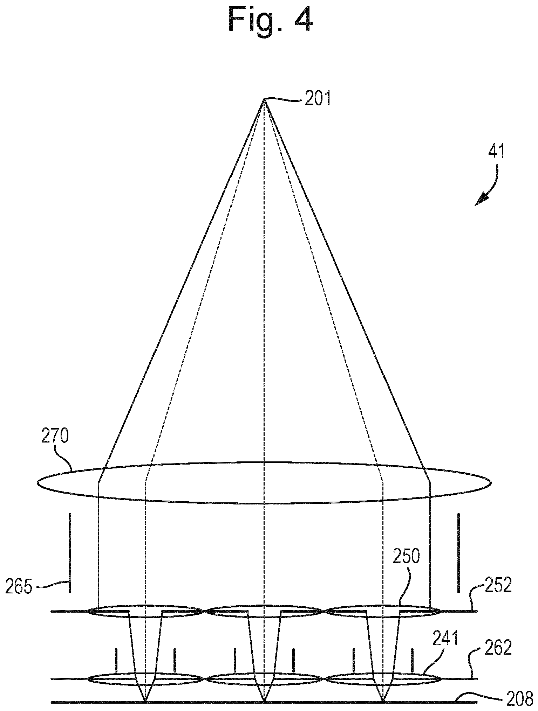

Each condenser lens 231 in the array directs electrons into a respective sub-beam 211, 212, 213 which is focused at a respective intermediate focus downbeam of the condenser lens array. The sub-beams diverge with respect to each other. In an embodiment, deflectors 235 are provided at the intermediate focuses. The deflectors 235 are positioned in the sub-beam paths at, or at least around, the position of the corresponding intermediate points of focus. The deflectors 235 are positioned in or close to the sub-beam paths at the intermediate image plane of the associated sub-beam. The deflectors 235 are configured to operate on the respective sub-beams 211, 212, 213. The deflectors 235 are configured to bend a respective sub-beam 211, 212, 213 by an amount effective to ensure that the principal ray (which may also be referred to as the beam axis) is incident on the sample 208 substantially normally (i.e. at substantially 90° to the nominal surface of the sample). The deflectors 235 may also be referred to as collimators or collimator deflectors. The deflectors 235 in effect collimate the paths of the sub-beams so that before the deflectors, the sub-beam paths with respect to each other are diverging. Downbeam of the deflectors the sub-beam paths are substantially parallel with respect to each other, i.e. substantially collimated. Suitable collimators are deflectors disclosed in EP Application 20156253.5 filed on 7 February 2020 which is hereby incorporated by reference with respect to the application of the deflectors to a multi-beam array. The collimator may comprise a macro collimator 270 (e.g. as shown in **FIG. 4**), instead of, or in addition to the deflectors 235. Thus, the macro-collimator 270 described below in relation **to** **FIG. 4** may be provided with the features of **FIG. 3****.** This is generally less preferred than providing the collimator array as deflectors 235.

Below (i.e. downbeam or further from source 201) the deflectors 235 there is a control lens array 250. The sub-beams 211, 212, 213 having passed through the deflectors 235 are substantially parallel on entry to the control lens array 250. The control lenses pre-focus the sub-beams (e.g. apply a focusing action to the sub-beams prior to the sub-beams reaching the objective lens array 241). The pre-focusing may reduce divergence of the sub-beams or increase a rate of convergence of the sub-beams. The control lens array 250 and the objective lens array 241 operate together to provide a combined focal length. Combined operation without an intermediate focus may reduce the risk of aberrations.

In further detail, it is desirable to use the control lens array 250 to determine the landing energy. However, it is possible to use in addition the objective lens array 241 to control the landing energy. In such a case, a potential difference over the objective lens is changed when a different landing energy is selected. One example of a situation where it is desirable to partly change the landing energy by changing the potential difference over the objective lens is to prevent the focus of the sub-beams getting too close to the objective lenses. In such a situation there is a risk of components of the objective lens array 241 having to be too thin to be manufacturable. The same may be said about a detector at this location. This situation can for example occur in case the landing energy is lowered. This is because the focal length of the objective lens roughly scales with the landing energy used. By lowering the potential difference over the objective lens, and thereby lowering the electric field inside the objective lens, the focal length of the objective lens is made larger again, resulting in a focus position further below the objective lens. Note that use of just an objective lens would limit control of magnification. Such an arrangement could not control demagnification and/or opening angle. Further, using the objective lens to control the landing energy could mean that the objective lens would be operating away from its optimal field strength. That is unless mechanical parameters of the objective lens (such as the spacing between its electrodes) could be adjusted, for example by exchanging the objective lens.

The control lens array 250 comprises a plurality of control lenses. Each control lens comprises at least two electrodes (e.g. two or three electrodes) connected to respective potential sources. The control lens array 250 may comprise two or more (e.g. three) plate electrode arrays connected to respective potential sources. The control lens array 250 is associated with the objective lens array 241 (e.g. the two arrays are positioned close to each other and/or mechanically connected to each other and/or controlled together as a unit). Each control lens may be associated with a respective objective lens. The control lens array 250 is positioned upbeam of the objective lens array 241.

The control lens array 250 comprises a control lens for each sub-beam 211, 212, 213. A function of the control lens array 250 is to optimize the beam opening angle with respect to the demagnification of the beam and/or to control the beam energy delivered to the objective lens array 241 which directs the sub-beams 211, 212, 213 onto the sample 208. The objective lens array 241 may be positioned at or near the base of the electron-optical system 41. The control lens array 250 is optional, but is preferred for optimizing a sub-beam upbeam of the objective lens array.

For ease of illustration, lens arrays are depicted schematically herein by arrays of oval shapes (as shown in **FIG. 3**). Each oval shape represents one of the lenses in the lens array. The oval shape is used by convention to represent a lens, by analogy to the biconvex form often adopted in optical lenses. In the context of charged-particle arrangements such as those discussed herein, it will be understood however that lens arrays will typically operate electrostatically and so may not require any physical elements adopting a biconvex shape. Lens arrays may instead comprise multiple plates with apertures.

Optionally, an array of scan deflectors 260 is provided between the control lens array 250 and the array of objective lenses 234. The array of scan deflectors 260 comprises a scan deflector for each sub-beam 211, 212, 213. Each scan deflector is configured to deflect a respective sub-beam 211, 212, 213 in one or two directions so as to scan the sub beam across the sample 208 in one or two directions.

**FIG. 4** is a schematic diagram of an exemplary charged particle assessment system 40 having an alternative electron-optical system 41. The electron-optical system 41 comprises an objective lens array 241. The objective lens array 241 comprises a plurality of objective lenses. The objective lens array 241 may be an exchangeable module. For conciseness, features of the objective lens array 241 that have already been described above may not be repeated here.

The electron-optical device 41 can be used for the detection of electrons in the system of **FIG. 4****.** As shown in **FIG. 4****,** the electron-optical system 41 comprises a source 201. The source 201 provides a beam of charged particles (e.g. electrons). The multi-beam focused on the sample 208 is derived from the beam provided by the source 201. Sub-beams may be derived from the beam, for example, using a beam limiter defining an array of beam-limiting apertures. The array of beam-limiting apertures may defines the mutual arrangement of the sub-beams in the multi-beam arrangement of the multi-beam. The beam may separate into the sub-beams on meeting the control lens array 250. The most upbeam electrode of the control lens array may be such a beam limiter with an array of beam-limiting apertures. The sub-beams are substantially parallel on entry to the control lens array 250. The source 201 is desirably a high brightness thermal field emitter with a good compromise between brightness and total emission current as noted with the arrangement described with reference to **FIG. 3****.**

In the example shown, a collimator is provided upbeam of the objective lens array assembly. The collimator may comprise a macro collimator 270. The macro collimator 270 acts on the beam from the source 201 before the beam has been split into a multi-beam. The macro collimator 270 bends respective portions of the beam by an amount effective to ensure that a beam axis of each of the sub-beams derived from the beam is incident on the sample 208 substantially normally (i.e. at substantially 90° to the nominal surface of the sample 208). The macro collimator 270 applies a macroscopic collimation to the beam. The macro collimator 270 may thus act on all of the beam rather than comprising an array of collimator elements that are each configured to act on a different individual portion of the beam. The macro collimator 270 may comprise a magnetic lens or magnetic lens arrangement comprising a plurality of magnetic lens sub-units (e.g. a plurality of electromagnets forming a multi-pole arrangement). Alternatively or additionally, the macro-collimator may be at least partially implemented electrostatically. The macro-collimator may comprise an electrostatic lens or electrostatic lens arrangement comprising a plurality of electrostatic lens sub-units. The macro collimator 270 may use a combination of magnetic and electrostatic lenses.

In another arrangement (not shown), the macro-collimator may be partially or wholly replaced by a collimator element array provided downbeam of the upper beam limiter. Each collimator element collimates a respective sub-beam. The collimator element array may be formed using MEMS manufacturing techniques so as to be spatially compact. The collimator element array may be the first deflecting or focusing electron-optical array element in the beam path downbeam of the source 201. The collimator element array may be upbeam of the control lens array 250. The collimator element array may be in the same module as the control lens array 250.

In the embodiment of **FIG. 4** a macro scan deflector 265 is provided to cause sub-beams to be scanned over the sample 208. The macro scan deflector 265 deflects respective portions of the beam to cause the sub-beams to be scanned over the sample 208. In an embodiment, the macro scan deflector 265 comprises a macroscopic multi-pole deflector, for example with eight poles or more. The deflection is such as to cause sub-beams derived from the beam to be scanned across the sample 208 in one direction (e.g. parallel to a single axis, such as an X axis) or in two directions (e.g. relative to two non-parallel axes, such as X and Y axes). The macro scan deflector 265 acts macroscopically on all of the beam rather than comprising an array of deflector elements that are each configured to act on a different individual portion of the beam. In the embodiment shown, the macro scan deflector 265 is provided between the macro collimator 270 and the control lens array 250.

In another arrangement (not shown), the macro scan deflector 265 may be partially or wholly replaced by a scan deflector array. The scan-deflector array comprises a plurality of scan deflectors. The scan-deflector array may be formed using MEMS manufacturing techniques. Each scan deflector scans a respective sub-beam over the sample 208. The scan-deflector array may thus comprise a scan deflector for each sub-beam. Each scan deflector may deflect the sub-beam in one direction (e.g. parallel to a single axis, such as an X axis) or in two directions (e.g. relative to two non-parallel axes, such as X and Y axes). The deflection is such as to cause the sub-beam to be scanned across the sample 208 in the one or two directions (i.e. one dimensionally or two dimensionally). The scan deflector array may be upbeam of an objective lens array 241. The scan deflector array may be downbeam of a control lens array 250. Although reference is made to a single sub-beam associated with a scan deflector, groups of sub-beams may be associated with a scan deflector. In an embodiment, the scanning deflectors described in EP2425444, which document is hereby incorporated by reference in its entirety specifically in relation to scan deflectors, may be used to implement the scan-deflector array. A scan-deflector array (e.g. formed using MEMS manufacturing techniques as mentioned above) may be more spatially compact than a macro scan deflector. The scan deflector array may be in the same module as the objective lens array 241.

In other embodiments both a macro scan deflector 265 and the scan-deflector array are provided. In such an arrangement, the scanning of the sub-beams over the sample surface may be achieved by controlling the macro scan deflector and the scan-deflector array together, preferably in synchronization.

In some embodiments, the electron-optical system 41 further comprises an upper beam limiter 252. The upper beam limiter 252 defines an array of beam-limiting apertures. The upper beam limiter 252 may be referred to as an upper beam-limiting aperture array or upbeam beam-limiting aperture array. The upper beam limiter 252 may comprise a plate (which may be a plate-like body) having a plurality of apertures. The upper beam limiter 252 forms sub-beams from a beam of charged particles emitted by the source 201. Portions of the beam other than those contributing to forming the sub-beams may be blocked (e.g. absorbed) by the upper beam limiter 252 so as not to interfere with the sub-beams downbeam. The upper beam limiter 252 may be referred to as a sub-beam defining aperture array.

In some embodiments, as exemplified in **FIG. 4****,** the objective lens array assembly (which is a unit that comprises the objective lens array 241) further comprises a beam shaping limiter 262. The beam shaping limiter 262 defines an array of beam-limiting apertures. The beam shaping limiter 262 may be referred to as a lower beam limiter, lower beam-limiting aperture array or final beam-limiting aperture array. The beam shaping limiter 262 may comprise a plate (which may be a plate-like body) having a plurality of apertures. The beam shaping limiter 262 may be downbeam from at least one electrode (optionally from all electrodes) of the control lens array 250. In some embodiments, the beam shaping limiter 262 is downbeam from at least one electrode (optionally from all electrodes) of the objective lens array 241.

In an arrangement, the beam shaping limiter 262 is structurally integrated with an electrode of the objective lens array 241. Desirably, the beam shaping limiter 262 is positioned in a region of low electrostatic field strength. Each of the beam-limiting apertures is aligned with a corresponding objective lens in the objective lens array 241. The alignment is such that a portion of a sub-beam from the corresponding objective lens can pass through the beam-limiting aperture and impinge onto the sample 208. Each beam-limiting aperture has a beam limiting effect, allowing only a selected portion of the sub-beam incident onto the beam shaping limiter 262 to pass through the beam-limiting aperture. The selected portion may be such that only a portion of the respective sub-beam passing through a central portion of respective apertures in the objective lens array reaches the sample. The central portion may have a circular cross-section and/or be centered on a beam axis of the sub-beam.

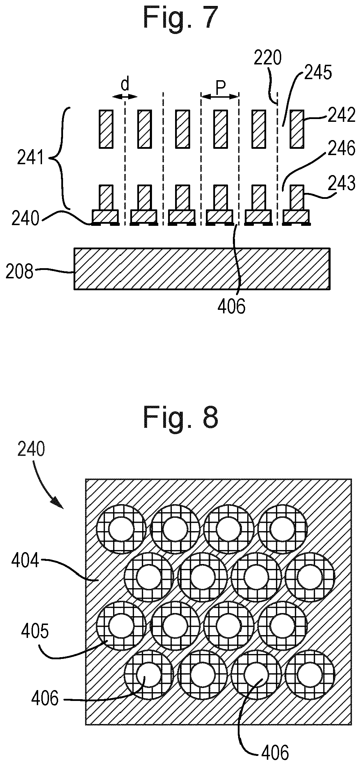

Any of the objective lens array assemblies described herein may further comprise a detector 240. The detector detects electrons emitted from the sample 208. The detected electrons may include any of the electrons detected by an SEM, including secondary and/or backscattered electrons emitted from the sample 208. An exemplary construction of a detector 240 is shown in **FIG. 3** and described in more detail below with reference to **FIGs. 7-10****.**

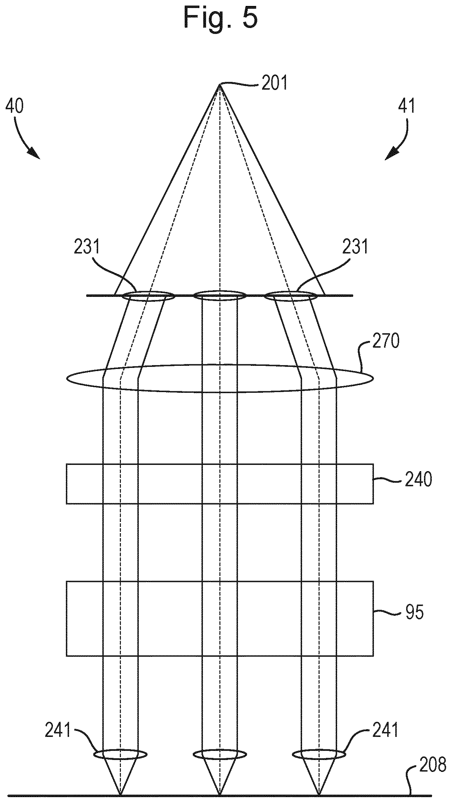

**FIG. 5** schematically depicts a charged particle assessment system 40 according to an embodiment. Features that are the same as those described above are given the same reference numerals. For conciseness, such features are not described in detail with reference to **FIG. 5****.** For example, the source 201, the condenser lenses 231, the macro collimator 270, the objective lens array 241 and the sample 208 may be as described above.

As described above, in an embodiment the detector 240 is between the objective lens array 241 and the sample 208. The detector 240 may face the sample 208. Alternatively, as shown in **FIG. 5****,** in an embodiment the objective lens array 241, which comprises the plurality of objective lenses, is between the detector 240 and the sample 208.

In an embodiment a deflector array 95 is between the detector 240 and the objective lens array 241. In an embodiment the deflector array 95 comprises a Wien filter (or even a Wien filter array) so that deflector array may be referred to as a beam separator. The deflector array 95 is configured to provide a magnetic field to disentangle the charged particles projected to the sample 208 from the secondary electrons from the sample 208.

In an embodiment the detector 240 is configured to detect signal particles by reference to the energy of the charged particle, i.e. dependent on a band gap. Such a detector 240 may be called an indirect current detector. The secondary electrons emitted from the sample 208 gain energy from the fields between the electrodes. The secondary electrodes have sufficient energy once they reach the detector 240.

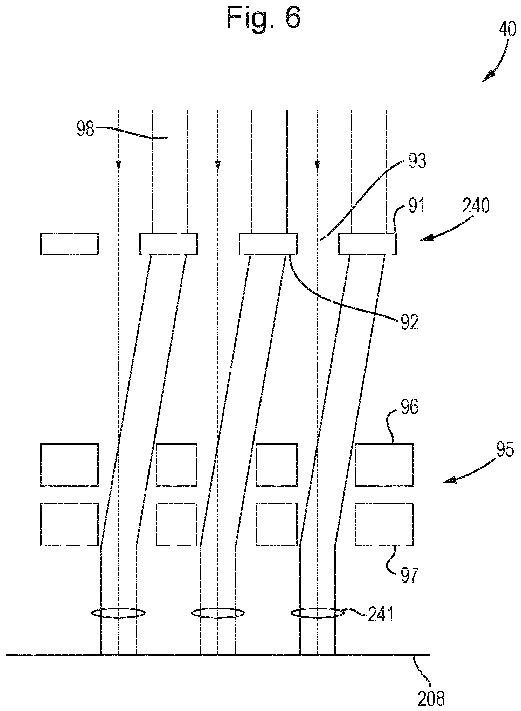

**FIG. 6** is a close-up view of part of the charged particle assessment system 40 shown in **FIG. 5****.** In an embodiment the detector 240 comprises an electron to photon converter array 91. The electron to photon converter array 91 comprises a plurality of fluorescent strips 92, such as scintillators. Each fluorescent strip 92 is located in the plane of the electron to photon converter array 91. At least one fluorescent strip 92 is arranged between two adjacent charged particle beams projected towards the sample 208. In an arrangement a fluorescent strip, or indeed each fluorescent strip 92, may cross the path of the multi-beam, namely the arrangement of sub-beams in the multi-beam arrangement.

In an embodiment, the fluorescent strips 92 extend substantially in the horizontal direction. Alternatively, the electron to photon converter array 91 may comprise a plate of a fluorescent material with openings 93 for the projected charged particle beams.

The projected charged particle beams, indicated by dashed lines in **FIG. 6****,** are projected through the plane of the electron to photon converter array 91, via the openings 93 between the fluorescent strips 92, towards the deflector array 95.

In an embodiment the deflector array 95 comprises a magnetic deflector 96 and an electrostatic deflector 97. The electrostatic deflector 97 is configured to counteract the deflection of the magnetic deflector 96 for the projected charged particle beams transmitted towards the sample 208. Accordingly, the projected charged particle beams may be shifted to a small extent in the horizontal plane. The beams downbeam of the deflector array 95 are substantially parallel to the beams upbeam of the deflector array 95.

In an embodiment the objective lens array 241 comprises a plurality of plates for guiding secondary electrons created in the sample 208 towards the deflector array 95. For the secondary electrons, which travel in opposite direction with respect to the projected charged particle beams, the electrostatic deflector 97 does not counteract the deflection of the magnetic deflector 96. Instead, the deflections of the secondary electrons by the electrostatic deflector 97 and the magnetic deflector 96 add up. Accordingly, the secondary electrons are deflected to travel at an angle with respect to the optical axis in order to transmit the secondary electrons onto the fluorescent strips 92 of the detector 240.

At the fluorescent strips 92, photons are created upon incidence of the secondary electrons. In an embodiment, the photons are transported from the fluorescent strip 92 to a photo detector (not shown) via a photon transport unit. In an embodiment, the photon transport unit comprises an array of optical fibers 98. Each optical fiber 98 comprises an end which is arranged adjacent or attached to one of the fluorescent strips 92 for coupling photons from the fluorescent strip 92 into the optical fiber 98, and another end which is arranged to project photons from the optical fiber 98 onto the photo detector.

The objective lens array 241 of any embodiment may comprise at least two electrodes in which are defined aperture arrays. In other words, the objective lens array comprises at least two electrodes with a plurality of holes or apertures. **FIG. 7** shows electrodes 242, 243 which are part of an exemplary objective lens array 241 having respective aperture arrays 245, 246. The position of each aperture in an electrode corresponds to the position of a corresponding aperture in another electrode. The corresponding apertures operate in use on the same beam, sub-beam or group of beams in the multi-beam. In other words, corresponding apertures in the at least two electrodes are aligned with and arranged along a sub-beam path, i.e. one of the sub-beam paths 220. Thus, the electrodes are each provided with apertures through which the respective sub-beam 211, 212, 213 propagates.

The objective lens array 241 may comprise two electrodes, as shown in **FIG. 7** **,** or three electrodes, or may have more electrodes (not shown). An objective lens array 241 having only two electrodes can have lower aberration than an objective lens array 241 having more electrodes. A three-electrode objective lens can have greater potential differences between the electrodes and so enable a stronger lens. Additional electrodes (i.e. more than two electrodes) provide additional degrees of freedom for controlling the electron trajectories, e.g. to focus secondary electrons as well as the incident beam. A benefit of two electrode lens over an Einzel lens is that the energy of an incoming beam is not necessarily the same as an out-going beam. Beneficially the potential differences on such a two electrode lens array enables it to function as either an accelerating or a decelerating lens array.

Adjacent electrodes of the objective lens array 241 are spaced apart from each other along the sub-beam paths. The distance between adjacent electrodes, in which an insulating structure might be positioned as described below, is larger than the objective lens.

Preferably, each of the electrodes provided in the objective lens array 241 is a plate. The electrode may otherwise be described as a flat sheet. Preferably, each of the electrodes is planar. In other words, each of the electrodes will preferably be provided as a thin, flat plate, in the form of a plane. Of course, the electrodes are not required to be planar. For example, the electrode may bow due to the force due to the high electrostatic field. It is preferable to provide a planar electrode because this makes manufacturing of the electrodes easier as known fabrication methods can be used. Planar electrodes may also be preferable as they may provide more accurate alignment of apertures between different electrodes.

The objective lens array 241 can be configured to demagnify the charged particle beam by a factor greater than 10, desirably in the range of 50 to 100 or more.

A detector 240 is provided to detect secondary and/or backscattered charged particles emitted from the sample 208. The detector 240 is positioned between the objective lenses 234 and the sample 208. The detector 240 may otherwise be referred to as a detector array or a sensor array, and the terms "detector" and "sensor" are used interchangeably throughout the application.

An electron-optical device 41 may be provided. The electron-optical device is configured to project a beam of electrons towards the sample 208 for example in a multi-beam as herein described in detail or in a single beam. The electron-optical device may comprise the objective lens array 241 for example as an objective lens array as herein described.. The electron-optical device may comprise the detector 240. The array of objective lenses (i.e. the objective lens array 241) may correspond with the array of detectors (i.e. the detector 240) and/or any of the beams (i.e. the sub-beams). However the invention may be applied to other arrangements of objective lens such as a magnetic objective lens arrangement for a single beam or a multi-beam. Such a magnetic objective lens arrangement may feature a single aperture for all beams towards the sample and optionally signal particles from the sample. The magnetic objective lens arrangement may comprise multiple magnetic lenses arranged along the beam path. The magnetic objective lens arrangement may feature electrode elements which may be positioned further downbeam e.g. closer to the sample during operation, than the magnetic elements than the magnetic objective lens arrangement

An exemplary detector 240 is described below. However, any reference to the detector 240 could be a single detector (i.e. at least one detector) for example for a single beam electron-optical system or multiple detectors as appropriate. The detector 240 may comprise detector elements 405 (e.g. sensor elements such as capture electrodes). The detector 240 may comprise any appropriate type of detector. For example, capture electrodes for example to detect directly electron charge, scintillators or PIN elements can be used. The detector 240 may be a direct current detector or an indirect current detector. The detector 240 may be a detector as described below in relation to **FIG. 8****,** **FIG. 9, FIG. 10****.**

The detector 240, for example in the embodiment depicted in and described with reference to **FIG. 7****,** may be positioned between the objective lens array 241 and the sample 208. The detector 240 is configured to be the most down-beam feature of the electron-optical device, for example proximate the sample 208. The detector 240 may be very close to the sample 208, for example less than 300 µm, preferably between 200 and 10 µm, more preferably between 100 and 30 µm, for example less than or equal to approximately fifty µm. Alternatively, there may be a larger gap between, the detector 240 and the sample 208, for example at the most 5 mm, for example at the most 3 mm more preferably at the most 1.5 mm; in an arrangement the gap is at least 750 µm such as for a single beam electron-optical apparatus.

The detector 240 may be positioned in the device so as to face the sample 208. Alternatively, the detector 240 may be positioned elsewhere in the electron-optical system 41 such that part of the electron-optical device that faces the sample 208 is other than, and thus is not, a detector; such as an electrode of the objective lens arrangement, for example the arrangement for a multi-beam electron-optical apparatus is shown in and described with reference to **FIGS. 5** **and** **6** in which the electrode facing the sample is part of an objective lens array. In such other arrangements, such as a single beam electron-optical system as mentioned, detector components may be located at different positions along the beam path, one or more of which may feature an array of detector elements for example as the feature of the electron-optical devices most down-beam, e.g. closest to the sample.

In an embodiment the gap between the electron-optical device and the sample 208 is at most about 1.5 mm. For a single beam system, the gap may be at least 0.75 mm. For a multi-beam system a distance L between the electron-optical device and the sample 208 is less than or equal to approximately 50 µm. The distance L is determined as the distance from a surface of the sample 208 facing the electron-optical system 41 and a surface of the electron-optical device facing the sample 208. Preferably, the distance L is less than or equal to approximately 40 µm. Preferably, the distance L is less than or equal to approximately 30 µm. Preferably, the distance L is less than or equal to approximately 20 µm. Preferably, the distance L is less than or equal to 10 µm.

**FIG. 8** is a bottom view of the detector 240 which comprises a substrate 404 on which are provided a plurality of detector elements 405 each surrounding a beam aperture 406. The beam apertures 406 may be formed by etching through the substrate 404. In the arrangement shown in **FIG. 8****,** the beam apertures 406 are in a hexagonal close packed array. The beam apertures 406 can also be differently arranged, e.g. in a rectangular array. The beam arrangement of the hexagonal arrangement in **FIG. 8** may be more densely packed than a square beam arrangement. The detector elements 405 may be arranged in a rectangular array or a hexagonal array.

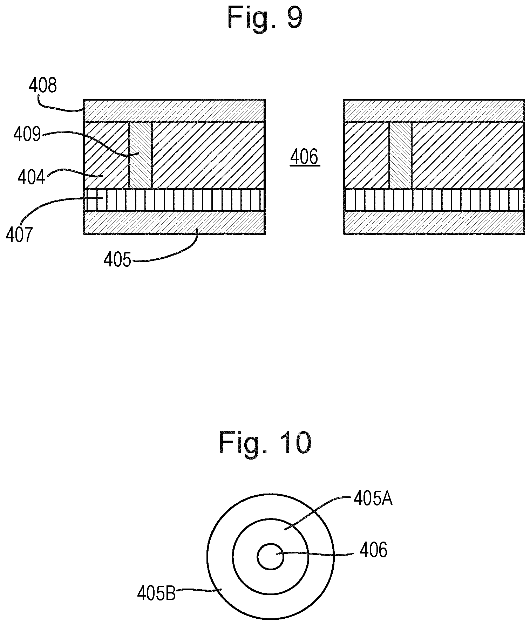

**FIG. 9** depicts at a larger scale a part of the detector 240 in cross section. The detector elements 405 form the bottommost, i.e. most close to the sample 208, surface of the detector 240. Between the detector elements 405 and the main body of the substrate 404 a logic layer 407 may be provided. At least part of the signal processing system may be incorporated into the logic layer 407.

A wiring layer 408 is provided on the backside of, or within, the substrate 404 and connected to the logic layer 407 by through-substrate vias 409. The number of through-substrate vias 409 need not be the same as the number of beam apertures 406. In particular if the electrode signals are digitized in the logic layer 407 only a small number of through-silicon vias may be required to provide a data bus. The wiring layer 408 can include control lines, data lines and power lines. It will be noted that in spite of the beam apertures 406 there is ample space for all necessary connections. The detection module 402 can also be fabricated using bipolar or other manufacturing techniques. A printed circuit board and/or other semiconductor chips may be provided on the backside of detector 240.

The integrated detector array described above is particularly advantageous when used with a tool having tunable landing energy as secondary electron capture can be optimized for a range of landing energies.

The detector 240 may be implemented by integrating a CMOS chip detector into an electrode of the objective lens array 241, such as the bottom electrode of the objective lens array 241. Integration of a detector 240 into the objective lens array 241 or other component of the electron-optical system 41 allows for the detection of electrons emitted in relation to multiple respective sub-beams. The CMOS chip is preferably orientated to face the sample (because of the small distance (e.g. 200 µm or less, 100 µm or less,50 µm or less, 40 µm or less, 30 µm or less, or 20 µm or less) between the sample and a bottom of the charged particle-optical device and/or electron-optical system). In an embodiment, detector elements 405 to capture the secondary charged particles are formed in the surface metal layer of the CMOS device. The detector elements 405 can be formed in other layers. Power and control signals of the CMOS may be connected to the CMOS by through-silicon vias. For robustness, preferably a passive silicon substrate with holes shields the CMOS chip from high E-fields.

In order to maximize the detection efficiency it is desirable to make the surface of the detector elements 405 as large as possible, so that substantially all the area of the objective lens array 240 (excepting the apertures) is occupied by detector elements 405. Additionally or alternatively, each detector element 405 has a diameter substantially equal to the array pitch (i.e. the aperture array pitch described above in relation to the electrodes of the objective lens assembly 241). Therefore, the diameter of each detector element may be less than approximately 600 µm, and preferably between approximately 50 µm and 500 µm. As described above, the pitch may be selected depending on the intended distance between the sample 208 and the detector 240. In an embodiment the outer shape of the detector element 405 is a circle, but this can be made a square to maximize the detection area. Also the diameter of the through-substrate via 409 can be minimized. A typical size of the electron beam is in the order of 5 to 15 µm.

In an embodiment, a single detector element 405 surrounds each beam aperture 406. In another embodiment, a plurality of detector elements 405 are provided around each beam aperture 406. The electrons captured by the detector elements 405 surrounding one beam aperture 406 may be combined into a single signal or used to generate independent signals. The detector elements 405 may be divided radially. The detector elements 405 may form a plurality of concentric annuluses or rings. The detector elements 405 may be divided angularly. The detector elements 405 may form a plurality of sector-like pieces or segments. The segments may be of similar angular size and/or similar area. The electrode elements may be separated both radially and angularly or in any other convenient manner.

However a larger surface for the detector elements 405 leads to a larger parasitic capacitance, so a lower bandwidth. For this reason it may be desirable to limit the outer diameter of the detector elements 405. Especially in case a larger detector element 405 gives only a slightly larger detection efficiency, but a significantly larger capacitance. A circular (annular) detector element 405 may provide a good compromise between collection efficiency and parasitic capacitance. Such a compromise is thus an optimized balance between the collection efficiency and the parasitic capacitance so that the detection signal from the detector is sufficient with acceptable if not minimal degradation by the parasitic capacitance.

A larger outer diameter of the detector element 405 may also lead to a larger crosstalk (sensitivity to the signal of a neighboring hole). This can also be a reason to make the outer diameter of the detector element 405 smaller. Especially in case a larger detector element 405 gives only a slightly larger detection efficiency, but a significantly larger crosstalk.

The charged particle current collected by detector element 405 is amplified, for example by an amplifier such as a TIA.

In an embodiment, the objective lens array 241 is an exchangeable module, either on its own or in combination with other elements such as the control lens array and/or detector array. The exchangeable module may be field replaceable, i.e. the module can be swapped for a new module by a field engineer. In an embodiment, multiple exchangeable modules are contained within the tool and can be swapped between operable and non-operable positions without opening the charged particle assessment system 40.

In an embodiment the exchangeable module comprises an electron-optical component, and specifically may be the charged particle-optical arrangement, which is on a stage permitting actuation for positioning of the component. In an embodiment the exchangeable module comprises a stage. In an arrangement the stage and the exchangeable module may be an integral part of the tool 40. In an arrangement the exchangeable module is limited to the stage and the device, such as the charged particle-optical arrangement, it supports. In an arrangement the stage is removable.

In an alternative design the exchangeable module comprising the stage is removable. The part of the charged particle assessment system 40 for the exchangeable module is isolatable, that is the part of the charged particle assessment system 40 is defined by a valve upbeam and a valve downbeam of the exchangeable module. The valves can be operated to isolate the environment between the valves from the vacuum upbeam and downbeam of the valves respectively enabling the exchangeable module to be removed from the charged particle assessment system 40 whilst maintaining the vacuum upbeam and downbeam of the part of the charged particle assessment system 40 associated with the exchangeable module. In an embodiment the exchangeable module comprises a stage. The stage is configured to support a device, such as the charged particle-optical arrangement, relative to the beam path. In an embodiment the module comprises one or more actuators. The actuators are associated with the stage. The actuators are configured to move the device relative to the beam path. Such actuation may be used to align the device and the beam path with respect to each other.

In an embodiment, the exchangeable module is a microelectromechanical systems (MEMS) module. MEMS are miniaturized mechanical and electromechanical elements that are made using microfabrication techniques. In an embodiment, the exchangeable module is configured to be replaceable within the charged particle assessment system 40. In an embodiment, the exchangeable module is configured to be field replaceable. Field replaceable is intended to mean that the module may be removed and replaced with the same or different module while maintaining the vacuum in which the electron-optical tool 40 is located. Only a section of the charged particle assessment system 40 is vented corresponding to the module is vented for the module to be removed and returned or replaced.

The control lens array 250 may be in the same module as an objective lens array 241, i.e. forming an objective lens array assembly or objective lens arrangement, or it may be in a separate module

In some embodiments, one or more aberration correctors are provided that reduce one or more aberrations in the sub-beams. The one or more aberration correctors may be provided in any of the embodiments, e.g. as part of the charged particle-optical device, and/or as part of an optical lens array assembly, and/or as part of an assessment system, and/or as part of an electron-optical arrangement. In an embodiment, each of at least a subset of the aberration correctors is positioned in, or directly adjacent to, a respective one of the intermediate foci (e.g. in or adjacent to the intermediate image plane). The sub-beams have a smallest cross-sectional area in or near a focal plane such as the intermediate plane. This provides more space for aberration correctors than is available elsewhere, i.e. upbeam or downbeam of the intermediate plane (or than would be available in alternative arrangements that do not have an intermediate image plane).

In an embodiment, aberration correctors positioned in, or directly adjacent to, the intermediate foci (or intermediate image plane) comprise deflectors to correct for the source 201 appearing to be at different positions for different beams. Correctors can be used to correct macroscopic aberrations resulting from the source that prevent a good alignment between each sub-beam and a corresponding objective lens.

The aberration correctors may correct aberrations that prevent a proper column alignment. Such aberrations may also lead to a misalignment between the sub-beams and the correctors. For this reason, it may be desirable to additionally or alternatively position aberration correctors at or near the condenser lenses 231 (e.g. with each such aberration corrector being integrated with, or directly adjacent to, one or more of the condenser lenses 231). This is desirable because at or near the condenser lenses 231 aberrations will not yet have led to a shift of corresponding sub-beams because the condenser lenses are vertically close or coincident with the beam apertures. A challenge with positioning correctors at or near the condenser lenses, however, is that the sub-beams each have relatively large sectional areas and relatively small pitch at this location, relative to locations further downstream. The aberration correctors may be CMOS based individual programmable deflectors as disclosed in EP2702595A1 or an array of multipole deflectors as disclosed EP2715768A2, of which the descriptions of the beamlet manipulators in both documents are hereby incorporated by reference.

In some embodiments, each of at least a subset of the aberration correctors is integrated with, or directly adjacent to, the objective lens array 241. In an embodiment, these aberration correctors reduce one or more of the following: field curvature; focus error; and astigmatism. Additionally or alternatively, one or more scanning deflectors (not shown) may be integrated with, or directly adjacent to, the objective lens array 241 for scanning the sub-beams 211, 212, 213 over the sample 208. In an embodiment, the scanning deflectors described in US 2010/0276606, which document is hereby incorporated by reference in its entirety, may be used.

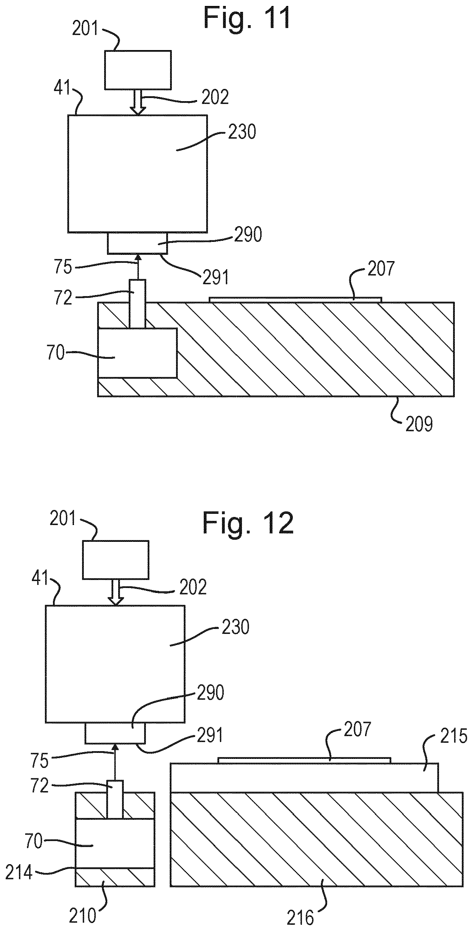

The detector may be provided with multiple portions and more specifically, multiple detecting portions. The detector comprising multiple portions may be associated with one of the sub-beams 211, 212, 213. Thus, the multiple portions of one detector 240 may be configured to detect signal particles emitted from the sample 208 in relation to one of the primary beams (which may otherwise be referred to as sub-beams 211, 212, 213). In other words, the detector comprising multiple portions may be associated with one of the apertures in at least one of the electrodes of the objective lens assembly. More specifically, the detector 405 comprising multiple portions may be arranged around a single aperture 406 as shown in **FIG 10****,** which provides an example of such a detector. In an embodiment, the single beam system of **FIG. 11** comprises such a detector comprising multiple portions.

As shown in **FIG. 10****,** the detector element 405, in which an aperture 406 is defined and configured for the through passage of a charged particle beam, comprises an inner detecting portion 405A and an outer detecting portion 405B. The inner detecting portion 405A surrounds the aperture 406 of the detector. The outer detecting portion 405B is radially outwards of the inner detecting portion 405A. The shape of the detector may be generally circular. Thus, the inner detecting portion and the outer detecting portion may be concentric rings.

The invention can be applied to various different tool architectures. For example, the charged particle assessment system 40 may be a single beam tool, or may comprise a plurality of single beam columns or may comprise a plurality of columns of multi-beams. The columns may comprise the electron-optical system 41 described in any of the above embodiments or aspects. As a plurality of columns (or a multi-column tool), the devices may be arranged in an array which may number two to one hundred columns or more. The charged particle assessment system 40 may take the form of an embodiment as described with respect to and depicted in **FIG. 3** or as described with respect to and depicted in **FIG. 4****,** although preferably having an electrostatic scan deflector array and an electrostatic collimator array. A charged particle column may optionally comprise a source.

As shown in **FIG. 2** (when read in context of the electron optical devices 41 as depicted in and described with respect to **FIGS. 3 to 5**), in an embodiment the projection assembly 60 comprises an optical system 63. In an embodiment, the projection system 60 comprises a light source 61. The light source 61 is configured to emit the light beam 62. In an embodiment the light source 61 is a laser light source. Laser light provides a coherent light beam 62. However, other types of light source can alternatively be used. As mentioned above the projection assembly 60 is used to illuminate a light beam 62 on the sample 208 so as to control the accumulated charges due to effects such as photoconductivity, photoelectric, or thermal effects; and thus regulate the accumulated charges on the sample.

In an embodiment the optical system 63 comprises a cylindrical lens 64. The cylindrical lens 64 is configured to focus the light beam 62 more in one direction than in an orthogonal direction. The cylindrical lens increases the design freedom for the light source 61. In an embodiment the light source 61 is configured to emit a light beam 62 having a circular cross section. The cylindrical lens 64 is configured to focus the light beam 62 such that the light beam has an elliptical cross section.

It is not essential for a cylindrical lens 64 to be provided. In an alternative embodiment another optical component can be used that is capable of focusing more strongly in one direction than another. In an alternative embodiment, the light source is configured to emit a light beam 62 that is elliptical or rectangular, for example. This is desirable to ensure the light beam reaches a portion of the sample required to be illuminated despite the small dimension between the sample and the most downbeam surface of the electron optical device 41 and the large dimension of the downbeam surface of the electron-optical device orthogonal to the orientation of the beam path.

In an embodiment the optical system 63 comprises reflecting surfaces 65, 66 such as mirrors. For example two reflecting surfaces 65, 66 may be provided. In an alternative embodiment, the optical system 63 does not reflect the light beam 62. In an alternative embodiment the optical system 63 may comprise one, three or more than three reflecting surfaces. The number and arrangement of the reflecting surfaces may be chosen depending on the dimensions of the volume in which the projection system 60 is required to fit. Such reflection surfaces may be desirable to improve the reach of the light beam 62 between the most downbeam surface of the electron optical device and the sample.

As explained above, in an embodiment the charged particle assessment system 40 comprises a detector 240 configured to detect signal particles emitted by the sample 208. As shown in **FIG. 3****,** in an embodiment, the detector 240 forms the most downbeam, with respect to the electron beam 211, 212, 213, surface of the electron-optical device 41. In other arrangements, as mentioned herein, the detector 240 may be associated with, and even comprise part of, the objective lens arrangement. For example the detector 240 may be associated with the objective lens array but a different position along the primary beam path, such associated with an electrode of the objective lens array, just upbeam of the objective lens array, distributed at different positions along the beam path in proximity and within the objective lens arrayment. In another arrangement the detector is located in a secondary column adjoining or connected to the charged particle column comprising the electron-optical device 41. In all these arrangements there is a most downbeam element of the electron-optical system, such as detector 240, most proximate to the sample. The most downbeam surface of the most downbeam element may face the sample. The most downbeam surface may be referred to as a facing surface.

Reference is now made to **FIG. 11****,** which is a schematic diagram illustrating a charged particle assessment system according to an embodiment, comprising a charged particle system. The charged particle assessment system comprises an electron-optical device 41 comprising a cleaning target 290. The charged particle assessment system additionally comprises a sample holder 207, and a cleaning device 70.

The electron-optical device 41 of **FIG. 11** comprises an electron source 201 and a projection apparatus 230. The projection apparatus 230 is configured to direct a beam of electrons from the electron source 201 downbeam towards a sample 207, for example during sample inspection.

The cleaning device is configured to supply cleaning medium in a cleaning flow 75 towards the cleaning target. The cleaning flow 75 approaches the cleaning target from downbeam of the cleaning target and is incident on the cleaning target. The cleaning device is configured such that the cleaning medium is stimulated at or near the cleaning target such that the cleaning medium cleans at least a portion of the surface 291 of the cleaning target 290. Desirably the distance between the place where the cleaning medium is stimulated and the cleaning target is less than about 100 mm, desirably less than about 10 mm.

The cleaning target is, for example, a component of the electron-optical device 41. As described above, components of the electron-optical device 41 may become contaminated, for example by hydrocarbon depositions. In particular, electron-optical elements of the projection apparatus 230, for example the objective lens array 241 and/or the detector 240, can become contaminated. Such contamination may derive from resist coatings that remain from earlier processing of the sample. In an application of the charged particle assessment apparatus, the resist may derive from samples assessed during after development inspection. In after development inspection samples exposed with a pattern are inspected after development but before etch. The resist coating may fully cover such a sample. Inspecting such a resist covered sample is likely to be a source of a greater quantity of contamination than a sample inspected after etch when the majority if not all the resist coating is removed from the sample.

A sample inspected after etch may still be a contamination source during inspection because of the closeness, proximity or small clearance between the sample and the facing surface of the electron-optical device 41. The cleaning target is preferably an electron-optical element of the electron-optical device 41, more preferably the cleaning target is the objective lens array 241 and/or the detector 240. The cleaning target, for example the detector, is preferably disposed in close proximity to the position of sample. For example, at least part of the cleaning target is preferably disposed at a cleaning distance from the position of the sample on the sample holder in the range of from 10 µm to 1 mm, preferably 10 to 200 µm, more preferably 20 to 150 µm, yet more preferably 30 to 80 µm from the position of the sample on the sample holder.

In the charged particle assessment system illustrated in **FIG. 11****,** the cleaning device 70 is disposed downbeam of the cleaning target and is configured to emit the cleaning medium in a cleaning flow 75 from downbeam of the cleaning target. The charged particle assessment system is configured such that in a cleaning condition the cleaning device 70 is disposed downbeam of the cleaning target. In particular, the charged particle assessment system illustrated in **FIG. 11** is configured such that in the cleaning condition the cleaning device 70 is disposed downbeam of the electron-optical device 41. That is, in the cleaning condition the cleaning device 70 is positioned into a cleaning position so that the cleaning device is downbeam of the cleaning target. Preferably the guide part comprises a deflector and/or a guidance tube. Preferably the guide part is configured to guide the cleaning flow along part of the cleaning path from a position downbeam of the optical system to the cleaning target.

The charged particle assessment system is configured such that in an assessment condition the electron-optical device 41 is disposed upbeam of a sample on the sample holder 207. In the assessment condition the relative positions of the sample and the electron-optical device 41 may be moved through a range of relative positions such that the electron-optical device 41 can operate so that sample maybe assessed. In the embodiment illustrated in **FIG. 11****,** the sample holder 207 is supported on a sample stage 209 which may be actuatable and so may be referred as an actuated stage 209, for example a motorized stage . The actuated stage 209 if preferably configured to be movable. The cleaning device 70 is supported by the actuated stage 209. More particularly, in the embodiment of **FIG. 11** the cleaning device 70 is disposed within the actuated stage 209.

The actuated stage 209 is movable, to change the relative positions of the electron-optical device 41 and of the sample holder 207 and the cleaning device 70, between the assessment condition and the cleaning condition. Alternatively, or additionally, the electron-optical device 41 is movable to change the relative positions of the electron-optical device 41 and of the sample holder 207 and the cleaning device 70. Thus the action of one or both of the actuated stage 209 and the electron-optical device 41 enables the relative positions of the actuated stage 209 and the electron optical device to be adjusted: so that in an assessment condition, the electron optical device can be used to assess the sample on 207 on the actuated stage 209; and, so that in a cleaning condition the cleaning device is positioned relative to the cleaning target so that a cleaning flow of the cleaning medium can be used to clean the cleaning target. The actuated stage may be displaceable in up to six degrees of freedom relative to the path of charged particles from the electron optical device 41 to the position of the sample. The actuated stage 209 may be actuated in a direction in a plane orthogonal to the beam path. The actuated stage may be tilted relative to a direction in the plane orthogonal to the beam path and rotated around the beam path. The actuated stage may displaceable in a downbeam direction. Movement along the downbeam direction may help to ensure clearance between the cleaning target and the cleaning device. Such movement in any of the degrees of freedom relative to the path of the beam may be during operation of the cleaning device.

The sample stage optionally comprises a short stroke stage 215 (or short stage) and a long stroke stage 216 (or long stage). The short stage 215 is configured to support the sample holder 207. The short stage 215 is configured to be movable relative to the long stage 216. The range of movement is at the most around 5 mm, preferably 1mm, more preferably 500 µm, most preferably 350 µm. The long stage 216 is configured to support the short stage 215. The range of the long stroke 216 is sufficient to position the sample relative to the electron optical device 41; that is except for the fine resolution achievable by the short stroke 215. As illustrated in **FIG. 11****,** the cleaning device 70 is disposed in the sample stage 209, preferably the long stroke 216. It is preferred that the cleaning device is within the long stroke of the arrangement depicted in in FIG. 11 because the additional mass of the device does not influence the positioning of the sample 207 by short stroke which can have an accuracy of nanometers. In being within the long stroke 216, the device can be positioned further from the cleaning target 290 than if the device were positioned in the short stroke 215. In another embodiment, the cleaning device 70 may be disposed in the short stage 215 of the sample stage 209. The cleaning device 70 is preferably disposed in the long stage 215 of the sample stage.

In an embodiment, the cleaning device may be positioned in a surface of the sample stage 209 facing the cleaning target 290 that is recessed into the sample 209 stage relative to the sample holder 207. The surface of the sample stage 209 in which the cleaning device 70 may be positioned may be recessed, for example stepped in the direction of the beam path, relative to the sample surface. Situated in or on the recess of the sample stage 209, the cleaning device may have a larger clearance relative to the cleaning target. Situated in or on such a recessed surface, the cleaning device may be supported by the long stroke 216. The long stroke 216 may be actuatable in the direction of the beam path. The long stroke may be actuated to move the sample closer too or further from the electron optical device 41, which direction may be referred to as along the z axis. Since the device is either directly or indirectly (i.e. via short stroke 215) supported by the long stroke, the cleaning device may be positioned closer or further away in the beam path direction from the cleaning target. Preferably the cleaning device is moved by actuating the long stroke to position the cleaning device further from the cleaning sample. Such actuation ensures there is sufficient clearance between the cleaning device 70 and the cleaning target 290 for the cleaning device to positioned relative to the cleaning target so that the path of the cleaning flow is directly towards the cleaning target.

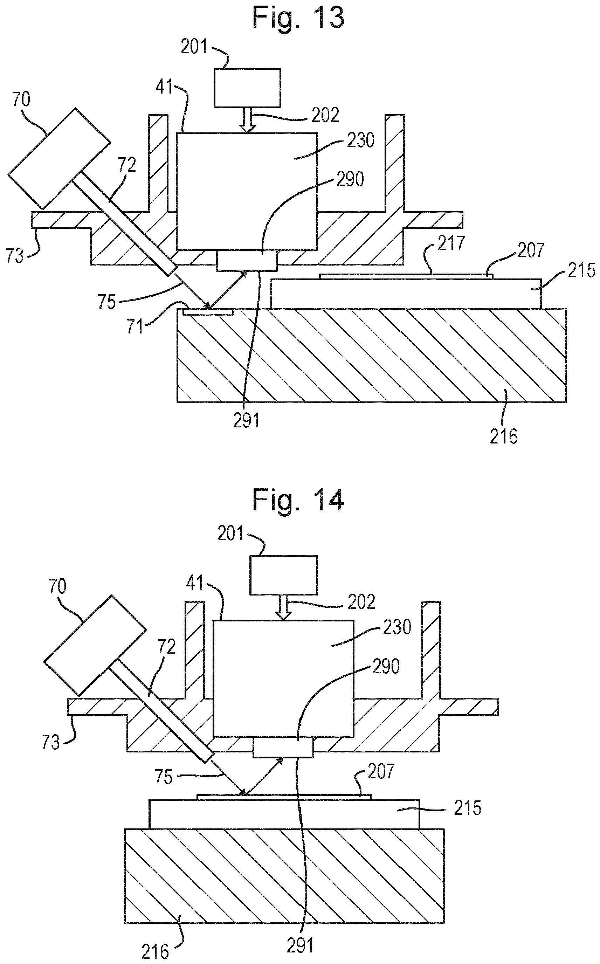

To aid directing the cleaning flow of the cleaning medium towards the cleaning target, the cleaning device 70 may have a cleaning guide 72. The cleaning guide it arranged to direct the path from the cleaning device 70 towards the cleaning target 290. Further details regarding the cleaning guide are disclosed and described with reference to FIG. 13 below.

The arrangement depicted features the sample stage 209 and thus the device 70 in a vacuum chamber (not depicted). Associated with the electron-optical device 41 may be a vacuum chamber. Therefore the sample stage 70, the electron-optical device, the cleaning device 70 and the cleaning target 290 may be in an under-pressure environment with an a vacuum chamber (not shown).

In an another embodiment, the cleaning device 70 is held by a cleaning device holder 210. In the embodiment illustrated by **FIG. 12****,** the cleaning device is disposed in the cleaning device holder 210. The arrangement depicted in **FIG. 12** has components that are the same as depicted in **FIG, 11** having the same reference number, function and structure unless otherwise mentioned. The cleaning device holder 210 may be separate from the actuated stage 209, which is arranged to support a sample 207. The cleaning device holder 210 may be supported and actuated by a cleaning stage 214. The movement of the cleaning device holder 210 is preferably independent of the movement of the actuated stage 209. The cleaning stage 214 may be independently positionable relative to the cleaning target.

The charged particle assessment system may be changed between the assessment condition and the cleaning condition by actuating the cleaning stage 214 and actuating the actuated stage 209. Thus the positions of the sample 207 and the cleaning device 70 may be exchanged between the assessment condition and the cleaning condition to take a position downbeam of the electron optical device 41. In an arrangement the cleaning stage 214 comprises a long stroke (not depicted) to actuate the stage. Preferably the cleaning stage 214 does not comprise a short stroke for fine positioning of the cleaning device relative to the cleaning target 290, although in embodiment the cleaning stage features a short stroke.

In an alternative configuration, the cleaning device is disposed upbeam of the sample holder. Preferably, in this configuration, the cleaning device is disposed upbeam of the most downbeam part of the charged particle optical system (which, as described above, may be referred to as an electron-optical device). Such a most downbeam part may have a downbeam surface that is at least part of the cleaning target. For example, in a preferred arrangement the cleaning device is disposed upbeam of the cleaning, e.g. of the cleaning target such as the detector. Preferably the cleaning device is apart from, for example spaced apart from, the charged particle optical system. In plan view, the cleaning device may located to the side of the the charged particle optical system.

In the charged particle assessment system illustrated in **FIG. 13****,** the cleaning device 70 is disposed upbeam of the sample and the cleaning target 290. With such an arrangement, the possibility of the cleaning device interfering with or restricting movement of the sample stage can be avoided. The arrangement depicted in **FIG. 13** has components that are the same as depicted in **FIGS. 11 or 12** having the same reference number, function and structure unless otherwise mentioned. The cleaning device 70 is configured to supply the cleaning medium in a cleaning flow 75 from upbeam of the projection apparatus 230. The cleaning medium flows in the cleaning flow 75 along a path directed away from the cleaning device 70. The charged particle assessment system illustrated in **FIG. 13** comprises cleaning guides 72, 71 configured to direct the cleaning flow 75 from the cleaning device 70 to the portion of the cleaning target. Preferably the cleaning guide is configured to direct the cleaning flow along a cleaning path from the cleaning device to the cleaning target.

The cleaning guides of **FIG. 13** include a flow deflector 71 disposed downbeam of the cleaning target. The flow deflector 71 is shown on the long stroke 216 of the sample stage 209. For example the flow deflector 71 is shown coplanar with the surrounding surface of a part of the stage. However, flow deflector 71 may be recessed into the sample stage or elevated relative to the surrounding surface of the sample stage; in an arrangement the flow deflector 71 may have a surface angled relative to the surrounding surface of the sample stage and/or the sample support 207. The present embodiment is beneficial because of the greater clearance between the flow deflector 71 and the cleaning target than between the sample or sample holder and the facing surface of the electron optical device 41. The sample stage may be actuated to adjust the clearance between the cleaning target 290 and flow defector 71. However other arrangements may exist for example the flow defector 71 may be situated on a short stroke 215 of the sample stage or the flow defector may 71 be located on a cleaning stage for example with a long stroke but without a short stroke.

The flow deflector 71 comprises a deflector surface configured to deflect the cleaning flow 75 upbeam towards the portion of the cleaning target to be cleaned by the cleaning flow. Conceptually the flow deflector may be considered to be a flow mirror, 'mirroring' the cleaning flow along a path that is incidental on the flow deflector from the direction of the cleaning device 70 in the direction of the cleaning target. In an arrangement, a flow deflector with a surface angled relative to the surface of the sample support 207, may be angled so as to preferentially deflect the cleaning flow towards the cleaning target. In this way, the cleaning flow 75 is directed from downbeam of the cleaning target. The cleaning flow 75 has a path towards the cleaning target that is in an upbeam direction towards the cleaning target, despite the cleaning device 70 being disposed upbeam of the cleaning target.

With this arrangement, it is possible to dispose the cleaning device 70 within the charged particle assessment apparatus. The charged particle assessment apparatus has sufficient volume to accommodate the cleaning device; that is the cleaning device may be readily positioned within the charged particle assessment apparatus without compromise to the function of either the charged particle assessment apparatus or the cleaning device. Furthermore, with this arrangement, the cleaning device 70 may be disposed outside of the vacuum environment. For example, as illustrated in **FIG. 13****,** a separating flange 73 is provided to separate the cleaning device 70 from the vacuum environment. The flange may separate (and thus join) two sections of the vacuum chamber and/or mount a component on the structure of the vacuum chamber. At least part of the cleaning device within the vacuum chamber may be secured, such as mounted, to the flange. The position of the cleaning device above the flange and adjacent the electron-optical device 41 is intended to indicate that the device, or at least that part of has the flange disposed between that part and the environment within the vacuum chamber, is outside the vacuum chamber that encloses the electron optical device and sample stage 209 and of which the flange 73 forms part. Having at least part of the cleaning device outside the vacuum chamber may be desirable for example parts of the cleaning device which comprise elements of the cleaning device which may interact with the functioning of the electron-optical device, such as electronics and electromagnetic elements such as coils. Note the precise arrangement of the flange 73 and other elements of the chamber wall are intended to be a schematic of the structural function of the flange and are not represent any specific structural configuration.

The deflector surface is positioned relative to the at least the portion of the cleaning target to deflect the cleaning flow towards the at least the portion of the surface of the cleaning target. The deflection of the cleaning flow towards the portion of the surface of the cleaning target surface may be improved by the shape the deflector surface may take. The position or shape or both the shape and position of the deflector surface may focus the cleaning flow on the surface of the cleaning target, preferably at least at the portion of the surface of the cleaning target.

At least in, and preferably in, the cleaning condition, the deflector surface is disposed such that the cleaning flow is directed from the cleaning device is incident on the portion of the cleaning target. As mentioned above, the sample holder 207 comprises a holding surface 217 configured to hold the sample. In an embodiment the holding surface may be recessed into the sample holder 207. The deflector surface of the flow deflector 71 is preferably disposed at a position preferably between 5 mm and 15 mm downbeam of the holding surface 217. However, the deflector surface can be as much as 100 mm downbeam of the holding surface. Preferably the flow deflector 71 is supported by the long stroke 216 of the sample holder 207 or alternatively of the cleaning stage 214, enabling the adjustment in the direction of the beam path to contribute if not further increase the clearance between the cleaning guide 71, for example the flow deflector 71, and the cleaning target 290.

The deflector surface may be planar. The deflector surface is preferably curved. Additionally or alternatively, the deflector surface optionally comprises an array of differently angled surfaces. With such topography, for example a curved arrangement, the detector surface can advantageously focus the cleaning flow, for example along a cleaning path, towards at least the portion of the cleaning target. Thus, the deflector surface may have a topography that functions for example so as to focus the cleaning flow along the cleaning path towards the cleaning target. Consequently, the cleaning medium is focused where it is needed and is not wasted on parts that do not require cleaning. Cleaning may therefore be faster and more efficient for example in time and in use of cleaning medium and energy.

The flow deflector 71, and/or other components and features of the cleaning device, may comprise a material resilient and durable to exposure to the cleaning medium. The flow deflector 71 preferably comprises a material that is chemically inert, in other words having low chemisorption. Furthermore, the material preferably has a low number of physisorption sites. A desired low number of physisorption sites can be obtained by ensuring that surfaces of the flow deflector are smooth. For example, the flow deflector 71 may comprise glass. Preferably, the flow deflector 71 comprises quartz.

The cleaning device may, for example, comprise a cleaning source configured to generate the cleaning medium. The cleaning medium can be any medium which reacts with the contamination deposited on the cleaning target to turn the contaminated deposit into a gas which can be extracted from the vacuum chamber, for example by pumping. The cleaning medium is, for example, a cleaning agent as described in EP3446325 and US20170304878, which is incorporated herein by reference, at least as far the disclosure of the cleaning agent and its generation. The cleaning medium may be a cleaning fluid. Preferably the cleaning medium is or comprises a gas or a plasma. The cleaning medium is generated as a consequence of creating a plasma, Preferably or alternatively the cleaning medium comprises radicals. The cleaning medium can be oxygen ions and/or radicals, or hydrogen ions and/or radicals. Preferably the cleaning medium comprises oxygen radicals, for example provided in the cleaning flow.

To increase the cleaning rate of the cleaning flow, stimulation energy is preferably provided to stimulate the cleaning medium at or near the cleaning target. The stimulation energy should be at least sufficient to enable a reaction of cleaning medium with chemical components of the contamination on the portion of the cleaning surface. Sufficient stimulation energy may for example be provided by bulk heating for example of the cleaning target such as a most downbeam electron-optical element such as the detector 240. Additionally or alternatively, the stimulation energy is supplied by the beam of charged particles, for example a beam of electrons during operation of the electron-optical device e.g. during assessment of a sample. Alternatively or additionally, the stimulation energy is provided by stimulating light, for example ultraviolet (UV) light, such as by illumination at least a portion of the surface of the cleaning target.

Bulk heating may be used to perform cleaning by supplying the cleaning flow during bake-out. During bake-out when the vacuum chamber is de-pressured or re-pressured. In bake-out the temperature of the electron-optical system 41 is typically elevated up to 100 degrees Celsius or more. Therefore, for the heat to supply stimulation energy to the cleaning medium, the cleaning flow is supplied while the temperature of the electron-optical system 41 is elevated. Thus, a heat source is configured to stimulate the cleaning medium at or near the cleaning target such that the cleaning medium cleans at least a portion of the cleaning target. The heat source may be configured to apply a heat load to the cleaning target.

Reference is now made to **FIG. 14****,** which is a schematic diagram illustrating a charged particle assessment system comprising an electron-optical system 41. The arrangement depicted in **FIG. 14** has components that are the same as depicted in and described with reference to any of **FIGS. 11, 12** **or** **13****,** including variants, having the same reference number, function and structure unless otherwise mentioned. The electron-optical system 41 is configured to project the beam of electrons towards the sample 207 for example during an assessment operation. It is intended that the cleaning operation occurs during operation of the electron optical device 41 in projecting an electron beam or multi-beam towards a sample or another surface. In this way, the electron-optical system 41 comprises in part the cleaning device 70. As shown, the cleaning device directs a cleaning flow towards the sample which deflectors (or mirrors) the cleaning flow towards the cleaning target. On operation of the electron-optical system 41, the electron beam is configured to stimulate the cleaning medium at or near the cleaning target such that the cleaning medium cleans at least a portion of the surface of the cleaning target.

This arrangement has the benefit that the cleaning device can be configured to operate to clean the portion of the cleaning target during operation of the charged particle assessment tool. Consequently, it is not necessary to delay assessment in order to perform cleaning operations. However, in a different arrangement, a flow deflector on the sample stage 209 or on a cleaning stage 214 may be positioned under the electron optical device 41. Note, the operation of the electron-optical device does not require the charged particle beam to be directed towards a sample for example for assessment.

The sample stage 209 (and optionally the cleaning stage) and the electron-optical system 41 are configured to be controlled such that the path of the electron beam is reflected upbeam onto at least the portion of clean target. The cleaning device may operate to generate a cleaning flow towards the flow deflector or sample and/or sample holder 207 which deflects (or mirrors) the cleaning flow towards the cleaning target whilst the electron-optical device is operating to generate an electron-optical beam. Consequently, the cleaning flow approaches the cleaning target from downbeam of the cleaning target. The electron beam may be deflected from the sample, the sample holder 207, or both. Such an arrangement may be beneficial because it enables cleaning of a cleaning target to be achieved in a continually operating electron optical device 41 without inducing instabilities in the operation of the source 201.

The cleaning device comprises a plasma generator configured to generate a plasma from which the cleaning medium is provided. In generating the plasma, the plasma generator emits photonic radiation. The photonic radiation may be light having wavelength such as UV light that stimulates the cleaning medium at the cleaning target when illuminating a portion of the cleaning target to clean at least the illuminated portion of the cleaning target. Additionally or alternatively the cleaning device comprises a photonic generator which is separate from the plasma generator. The photonic generator is a light emitter. Alternatively, a photonic generator may be provided separately from cleaning device 70.

In the embodiments of **FIG. 11** and **FIG. 12****,** the cleaning device 70 comprises a plasma generator; the cleaning device 70 has a light generating function. The cleaning medium may be plasma generated using the light emitted by the plasma generator. The light generated by the plasma generator may provide the stimulation energy for the cleaning of the target. Thus, the plasma provides stimulating light, particularly the generation of the plasma provides the stimulating light, more particularly UV light. So the plasma generator emits UV light. Additionally or alternatively the plasma generator may have a light emitter that may generate light preferably at a frequency of UV light. With this arrangement light emitted by the plasma generator, a separate light emitter or both, the stimulating light is provided along a light path from the cleaning device 70 to the portion of the cleaning target. The light is therefore directed along the same or a similar path from the cleaning device 70 as the cleaning flow. The stimulating light is directed towards the cleaning target such that the stimulating light is able to stimulate the cleaning medium at or near the cleaning target, for example so as to clean the surface of the cleaning target specifically the surface of near to the cleaning target.

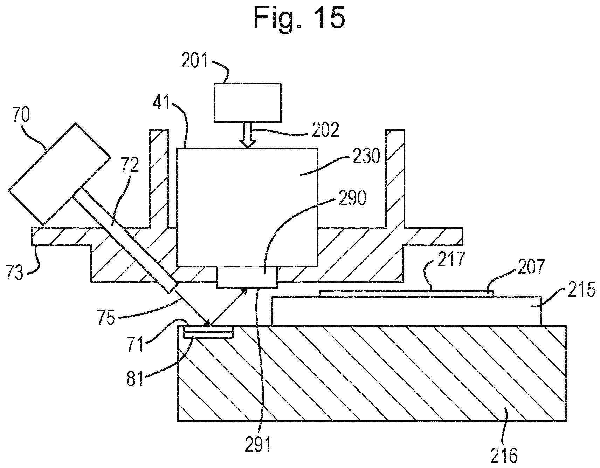

Reference is now made to **FIG. 15****,** which is a schematic diagram illustrating a charged particle assessment system similar to that of **FIG. 13****,** as described above. The arrangement depicted in **FIG. 145** has components that are the same as depicted in and described with reference to any of **FIGS. 11, 12****,** **13 and 14** including variants, having the same reference number, function and structure unless otherwise mentioned. The cleaning device 70 of the arrangement illustrated in **FIG. 15** has a cleaning medium generator optionally with a light emitter as described above. The charged particle assessment system of **FIG. 15** comprises at least one light guide configured to direct the stimulating light along a light path from the cleaning device 70 towards the portion of the cleaning target. Preferably the portion is to be cleaned using cleaning medium supplied by the cleaning device 70. The light guide of **FIG. 15** comprises a reflector 81. The reflector 81 is for reflecting the stimulating light from the cleaning device 70 towards the cleaning target, such as the portion of the detector to be cleaned. The reflector 81 is configured or simply arranged to reflect the stimulating light.

The reflector 81 comprises a reflector surface. The reflector surface is configured to reflect stimulating light. The reflector surface may be positioned relative to the at least the portion of the cleaning target to reflect, preferably focus, the stimulating light towards the at least the portion of the cleaning target surface. The reflector surface of the reflector surface may be shaped so that when positioned relative to the path of the stimulating light beam and the portion of the cleaning target to reflect, preferably focus, the stimulating light towards the at least the portion of the cleaning target surface.

The cleaning device 70 of the charged particle assessment system illustrated by **FIG. 15** is disposed in the same position with respect to the other components as described above with reference to the similar embodiment depicted in **FIG. 13****.** In an embodiment, the reflector surface may be substantially coplanar with the stage which supports the reflector surface. The reflector may be elevated relative to, or recessed into, the stage surface. The reflector may be angled with respect to a plane common to the supporting surface 207. The cleaning device 70 is therefore disposed upbeam in a direction along the electron beam path of at least the sample holder 207. The cleaning device is disposed optionally upbeam of the cleaning target. The reflector surface is disposed in a downbeam direction along the beam path of the cleaning target. In particular, as shown in **FIG. 15** the reflector surface is preferably disposed downbeam the electron-optical system 41. The reflector surface is preferably at a position between 5 mm and 15 mm downbeam of the holding surface 217 but can be as much as 100 mm from the holding surface.

The reflector surface may be planar. The reflector surface may reflect the stimulating light towards at least the portion of the cleaning target. The reflector surface may be preferentially angled with respect to the plane of the supporting surface to reflect the stimulating light to the cleaning target 290. The reflector surface is preferably curved. The reflector may be a compound surface of planar or curved elements approximating in function together as a curved surface. The reflector surface more preferably comprises a Fresnel lens. The reflector such as with a curved or Fresnel surface may advantageously focus the stimulating light towards at least the portion of the cleaning target for example along the light beam path to a point just before or just after the portion, maximizing the surface of the cleaning target cleaned. Yet, the stimulating light is directed to, for example focused on, a surface to be cleaned where it is needed and is not directed, for example wasted on, a surface that does not require cleaning, for example of a surface the cleaning target or a component around the cleaning target. Cleaning may therefore be completed faster and more efficiently for example in use of cleaning medium or stimulation energy per surface area cleaned.

In the arrangement illustrated by **FIG. 15****,** at least part of the flow deflector 71 is transparent to the stimulating light, i.e. the wavelength of the stimulating light. The flow deflector 71 is disposed between the cleaning device 70, which is configured to emit the stimulating light, and the reflector 81. The flow deflector 71 is disposed on an outer surface of the reflector 81. The outer surface of the reflector 81 is optionally the reflector surface.

In an alternative arrangement, the flow deflector is different and optionally spaced apart from the reflector. For example, the flow deflector and reflector may be offset with respective to each other in plane orthogonal to the charged particle beam path or in a plane coplanar with a supporting surface of the sample support 207.

Alternatively to having the reflector 81, another part of the cleaning apparatus, such as the flow deflector 71, may have the function of the reflector. In an arrangement a separate flow deflector 71 may not be required. In another arrangement the reflector 81 may not be required. Thus a redirector may thus simultaneously function to redirect towards the cleaning target from the cleaning device both the cleaning flow of the cleaning medium and the stimulating radiation.

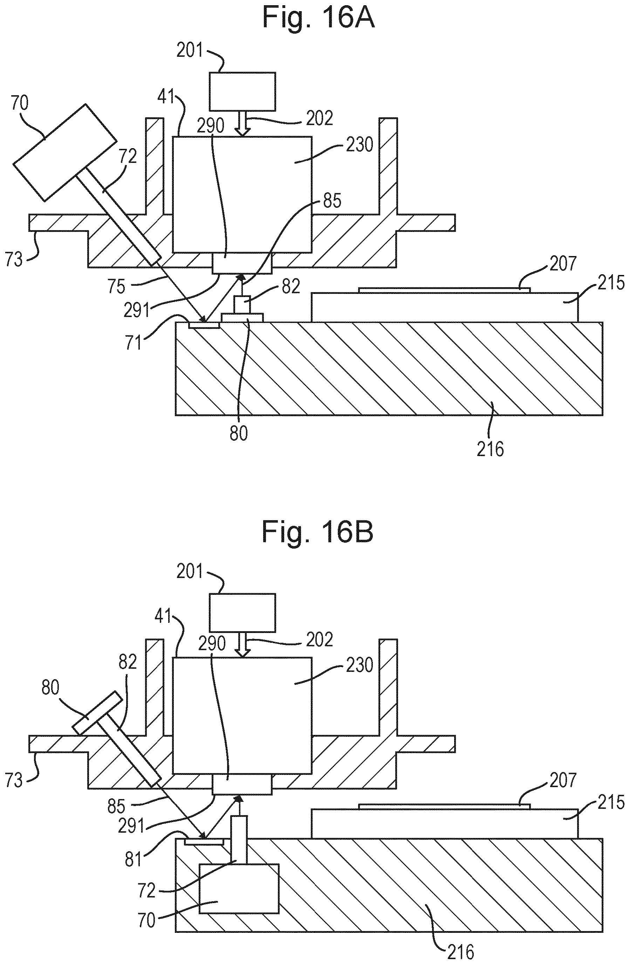

The charged particle assessment systems of **FIGS. 16A** and **FIG. 16B** comprise a light emitter 80. The arrangements depicted in each of **FIGS. 16A and 16B** each have components that are the same as depicted in and described with reference to any of **FIGS. 11, 12****,** **13, 14** **and** **15****,** including variants, having the same reference number, function and structure unless otherwise mentioned. The light emitter 80 is configured to emit stimulating light. The light emitter 80 is preferably a UV light emitter configured to emit UV light as the stimulating light. However the stimulating light can have any wavelength that is capable of stimulating the cleaning medium to clean upon illumination of the cleaning medium with the stimulating radiation. The stimulating light follows a light path 85 from the light emitter 80 to the portion of the cleaning target. The light emitter 80 may be an LED or a laser diode.

In an arrangement, the light emitter 80 may be associated with but separate from the cleaning device 70. For example, the light emitter may be arranged in the charged particle assessment system of **FIG. 11 or 12** associated with the cleaning device 70. The light emitter 80 may be positioned in the stage 209, 210 so that the emitted stimulating light is directed towards the cleaning target 290. In another arrangement, the light emitter may be connected or at least positioned adjacent or adjoining the cleaning device 70 of the charged particle assessment system of **FIG. 15** so as to direct the stimulating light along the same path as cleaning flow of a redirector so that stimulating light illuminates the cleaning target in the presence of the cleaning medium. In these arrangements, cleaning of at least a part of the cleaning target is thus effected.

Reference is now made to **FIG. 16A****,** which is a schematic diagram illustrating a charged particle assessment system similar to that of **FIG. 13****.** The light emitter 80 is disposed downbeam of the cleaning target and is configured to emit the stimulating light along a light path 85 from downbeam of the cleaning target. The light emitter 80 in the embodiment of **FIG. 16A** is preferably disposed at the same position as the cleaning device is disposed in the embodiment of **FIG. 11****.** The light emitter 80 in the embodiment of **FIG. 16A** is therefore preferably disposed in or on the sample stage 209.

The cleaning device 70 is disposed in a position upbeam of at least the sample holder 207. The cleaning device 70 in the embodiment of **FIG. 16A** is preferably disposed at the same position as the cleaning device 70 is disposed in the embodiments of **FIGS. 13** **and** **15****.** The flow deflector 71 in the embodiment of **FIG. 16A** is preferably disposed at the same position as the flow deflector 71 is disposed in the embodiments of **FIGS. 13** **and** **15****.**

The charged particle assessment system of **FIG. 16A** is therefore arranged such that the stimulating light is directed along the light path 85 to from the light emitter 80 to the portion of the cleaning target from downbeam of the cleaning target. The cleaning flow 75 is directed from the cleaning device 70 to the flow deflector 71. The flow deflector 71 deflects the cleaning medium such that the cleaning flow 75 is directed towards the cleaning target. The cleaning flow 75 is incident on the cleaning target so that cleaning flow 75 approaches the cleaning target from downbeam of the cleaning target. The cleaning flow 75 and the light path 85 are therefore directed to the cleaning target such that the stimulating light stimulates the cleaning medium at or near the cleaning target. The relative positions of the flow deflector 71, the light emitter 80 and the cleaning target, and optionally the angle of each of the flow deflector 71, the angle of illumination and thus light path 85 of the light emitter 80, and the topography, contribute to direct the stimulating light and cleaning medium to the cleaning target for cleaning

In an alternative embodiment, the light emitter 80 is disposed on a separate support such as an actuated stage, for example a light emitter holder, similar to the cleaning device holder 214 of **FIG. 12****.** The light emitter holder optionally comprises a stage 210 which is movable, preferably actuated. The stage 210 for the cleaning device may comprise an actuator. The cleaning device may be configured to support a cleaning guide such as the flow deflector 71 or reflector 81, so the cleaning guide may be referred to as a guide holder. Such a guide holder is configured to be positioned relative to the cleaning device and the portion of the cleaning target such that a part of the cleaning guide such reflector 81 is operational to reflect the stimulating light to the portion of the cleaning target. Additionally or alternatively, the guide holder is configured to be positioned relative to the cleaning device and the portion of the cleaning target such that any part of a cleaning guide, such as the flow deflector 71, between the cleaning device and the portion of the cleaning target, is operational to guide the cleaning flow to the portion of the cleaning target. A further additional embodiment or alternative embodiment is that the guide holder is configured to be positioned relative to the cleaning device so that a part of the cleaning guide both reflects the stimulating light and guides the cleaning flow.

Reference is now made to **FIG. 16B****,** which is a schematic diagram illustrating a charged particle assessment system similar to that of **FIG. 11****;** similar features take similar reference, including for variants, unless otherwise stated to the contrary. The light emitter 80 is disposed in a position upbeam (i.e. along the beam path) of at least the sample holder 207. The light emitter 80 in the embodiment of **FIG. 16B** is preferably disposed at the same position as the cleaning device 70 is disposed in the embodiments described with respect to the arrangements depicted in **FIGS. 13****,** **15** **and** **16A****.** With this arrangement, the light emitter 80 is preferably disposed outside of the vacuum environment. Such an arrangement is beneficial if the light emitter is bulky, for example a lasing arrangement. For example, as illustrated in **FIG. 16B****,** the separating flange 73 is provided to separate the light emitter 80 from the vacuum environment. The light emitter 80 may be mounted on or in the flange; such a position may be suited to a light emitter that is an LED or laser diode.

The charged particle assessment system of **FIG. 16B** is therefore arranged such that the cleaning flow 75 is directed from the cleaning device 70 to the portion of the cleaning target from downbeam of the cleaning target. The stimulating light is directed along the light path 85 from the light emitter 80 to the reflector 81. The reflector 81 reflects the stimulating light such that the stimulating light is directed towards the cleaning target. The stimulating light is incident on the cleaning target so that light path approaches the cleaning target from downbeam of the cleaning target. The cleaning flow 75 and the light path 85 are therefore directed to the cleaning target such that the stimulating light stimulates the cleaning medium at or near the cleaning target.

In an alternative embodiment, the cleaning device 70 is disposed on a separate support, for example the cleaning device holder 210 as shown and described in reference to **FIG. 12****.**

In the embodiment of **FIG. 16B****,** the reflector 81 is disposed on the actuated stage, particularly on the long stroke 215 of the actuated stage. Additionally or alternatively, the charged particle assessment system may further comprise an actuated holder which may be referred to as a guide holder. The guide holder 210 may configured to support the cleaning guide such as a reflector 81. The guide holder 210 may be similar to the cleaning device holder 210 described with reference to and as depicted in **FIG. 12** or the guide holder or light emitter holder depicted in an described in reference to **FIG. 16A****.** The guide holder is optionally configured to be movable, for example actuated. The guide holder preferably is comprised in or on a stage. The guide holder is configured to be positioned relative to the cleaning device and the portion of the cleaning target such that a part of a reflector 81 therebetween is operational to reflect the stimulating light to the portion of the cleaning target. Cleaning of the cleaning target is thereby effected.

Preferably, the cleaning device 70 of the embodiments of **FIG. 16A** and **FIG. 16B** may comprise a plasma generator, as described above with reference to **FIG. 15****.** In addition to supplying the cleaning flow 75, the plasma generator may contribute to the stimulation energy by providing stimulating light. That is, plasma generator may have a light generating function. The generated light may be UV light. The generated light be may be directed with the cleaning flow towards the cleaning target to contribute towards the stimulating light for cleaning the cleaning target.

In the arrangement of **FIG. 16A** the flow deflector 71 and reflector 81 may be arranged as described above with reference to and as depicted in **FIG. 15****.** At least part of the flow deflector 71 is transparent to stimulating light. At least a part of the flow deflector 71 is disposed between the cleaning device 70 and the reflector 81. The cleaning medium is deflected towards the cleaning target by the flow deflector 71 and the additional stimulating light provided by the cleaning flow is reflected towards the cleaning target by the reflector 81. Because the flow deflector 71 is transparent to the stimulating light, the reflector 81 does not inhibit the stimulating light from being incident on the reflector 81.

The charged particle assessment system may comprise a guidance tube. The guidance tube is part of the cleaning device to direct the cleaning flow of the cleaning medium towards where the cleaning medium is required for cleaning. For example, the cleaning device may take the form of a conduit or guidance tube similar to the cleaning agent source for introducing cleaning medium or cleaning agent into an electron-optical column as disclosed in US2017/0304878, which is hereby incorporated by reference at least in relation the operation and structure of the cleaning agent source (or cleaning device) and conduit (or guidance tube) and associated functionality. The guidance tube is optionally a cleaning guidance tube configured to direct the cleaning flow along at least part of a path of the cleaning flow from the cleaning device to the cleaning target. The cleaning guidance tube 72, for example in the embodiment as shown in and described with reference to **FIGS. 13****,** **15** **and** **16A****,** extends downbeam from the cleaning device 70. The cleaning guidance tube 72 is configured to direct the cleaning flow towards the flow deflector 71. The flow deflector 71 is positioned to deflect the cleaning flow towards the portion of the cleaning target.

The cleaning guidance tube 72, for example as shown in **FIGS. 11, 12** **and** **16B****,** is disposed to direct the cleaning flow upbeam from the cleaning device 70 towards the portion of the cleaning target. The cleaning guidance tube is therefore optionally supported by the same support which holds the cleaning device 70, for example the cleaning device holder 210 which may be comprised in the actuated stage 209.

The cleaning guidance tube 72 as depicted in **FIGS. 11 to 16** is a straight tube. Alternatively, the cleaning guidance tube can, for example, be curved or bent such that the cleaning guidance tube is configured to change the direction of the cleaning flow. The extent of the curve or deviation from a straight path may be limited to ensure that the cleaning medium reaches the cleaning target. The guidance tube may comprise the same material as the flow deflector. The guidance tube may comprise a material resilient and durable to exposure to the cleaning medium. The flow deflector preferably comprises a material that is chemically inert, in other words having low chemisorption, preferably with a low number of physisorption sites. For example, the flow deflector may comprise glass. Preferably, the flow deflector comprises quartz.

Alternatively, or additionally, the guidance tube functions a wave guide to direct light from the cleaning device. The guidance tube may function as a light guide, for example in the arrangements described with reference to and depicted in **FIGS. 12****,** **13** and **15** when featuring a plasma generator generating stimulating radiation which is directed along the cleaning path towards the cleaning target. Additionally or alternatively there may be a separate light emitter associated with the plasma generator to emit stimulating radiation along the cleaning path. The guidance tube thus functions to direct the stimulating light from the cleaning device 70 towards the cleaning target. The light guidance tube is configured to direct the stimulating light along at least part of a light path of the stimulating light from the light emitter (and/or the cleaning device if it comprises a plasma generator) towards the cleaning target. In a variation, the light guide is a separate structure from the guidance tube, such as one more optic fibers. Separate guiding structures may be used in parallel to direct the stimulating light along a light guide and a guidance tube for directing the cleaning flow, which may direct the light to a reflector, the cleaning flow towards a flow deflector, respectively, or to direct both the stimulating light and the cleaning flow towards a redirector, for redirecting the cleaning flow and cleaning light towards the cleaning target..

In another arrangement, the guidance tube may function as a light guide just for light. For example, the light guidance tube 82 of the arrangement described with reference to and as depicted in **FIG. 16B****,** extends downbeam from the light emitter 80. The light guidance tube 82 directs emitted light towards the reflector 8. Thus the light guidance tube 82 directs the stimulating light along a light path towards the reflector 81. The reflector 81 is positioned to reflect the stimulating light towards the portion of the cleaning target. In a variation, the light guidance tube 82 is a light guide which need not have the structural form of a tube. For example, the light guide may be one or more optic fibers, because in the arrangement shown in and described with reference to **FIG. 16B****,** the light guide serves to guide light. The light guide is not suitable for guiding a cleaning flow.

The light guidance tube 82, for example as shown in **FIG. 16A****,** is disposed to direct the stimulating light upbeam from the light emitter 80 towards the portion of the cleaning target. The light guidance tube is therefore optionally supported by the same support which holds the light emitter 80, for example the light emitter holder or the actuated stage 209.

The cleaning guidance tube 72, for example as shown in **FIG. 15****,** may be configured to direct both the cleaning flow and the stimulating light from the cleaning device 70, which comprises a photonic generator. Preferably, the inside of the cleaning guidance tube comprises an outer layer, optionally comprising the same material as described above for the flow deflector, configured to deflect the cleaning flow. The outer layer being transparent to stimulating light. The outer layer is disposed over an inner layer configured to reflect the stimulating light. In this way, the same guidance tube can direct both the cleaning flow and the stimulating light.

The guidance tube may be provided as an alternative or in addition to the flow deflector and/or the reflector.

The guidance tube has the advantage of targeting the cleaning flow and/or stimulating light in the desired direction such that cleaning medium and/or stimulating light is not wasted by being directed partly to components, surfaces or portions of surfaces that do not require cleaning.

There are provided the following clauses: Clause 1: A charged particle assessment system for projecting a beam of charged particles towards a sample, the system comprising: a sample holder configured to hold a sample; a charged particle optical system configured to project a beam of charged particles from a charged particle source downbeam towards the sample and comprising a cleaning target; a cleaning device configured: to supply cleaning medium in a cleaning flow towards the cleaning target incident on the cleaning target so that the cleaning flow approaches the cleaning target from downbeam of the cleaning target, and to stimulate the cleaning medium at or near the cleaning target such that the cleaning medium cleans at least a portion of the surface of the cleaning target.

Clause 2: The charged particle assessment system of clause 1, wherein the charged particle optical system comprises a plurality of electron-optical elements, and the cleaning target comprises one of the plurality of electron-optical elements.

Clause 3: The charged particle assessment system of clause 2, wherein: the plurality of electron-optical elements comprises an objective lens arrangement, configured to focus the beam of charged particles on the sample; and the cleaning target comprises the objective lens.

Clause 4: The charged particle assessment system of clause 2 or 3, wherein the electron-optical elements comprises a detector configured to detect signal particles emitted from the sample in response to the beam of charged particles.

Clause 5: The charged particle assessment system of clause 4, wherein the cleaning target comprises the detector.

Clause 6: The charged particle assessment system of clause 4 or 5, wherein the detector comprises an array of detector elements preferably each detector element is assigned to a sub-beam of the charged particle beam, preferably an aperture is defined in the detector for each sub-beam.

Clause 7: The charged particle assessment system of any of clauses 4 to 6, wherein the cleaning device is disposed upbeam of the detector, preferably apart from the charged particle optical system.

Clause 8: The charged particle assessment system of any of clauses 2 to 7, wherein one or more of the electron-optical elements comprises a plurality of plate electrodes in which one more apertures are defined for a path of the charged particle beam.

Clause 9: The charged particle assessment system of any preceding clause, wherein at least part of the cleaning target is positioned proximate to the sample.

Clause 10: The charged particle assessment system of any preceding clause, wherein the cleaning device comprises a cleaning guide configured to direct the cleaning flow to the cleaning target, preferably the cleaning guide is configured to direct the cleaning flow along a cleaning path to the cleaning target.

Clause 11: The charged particle assessment system of clause 10, further comprising a guide holder configured to support at least part of the cleaning guide.

Clause 12: The charged particle assessment system of clause 10 or 11, wherein the at least part of the cleaning guide is disposed in the support, preferably wherein the support is a stage.

Clause 13: The charged particle assessment system clause 12, wherein the sample holder or guide holder is configured to be positioned relative to the cleaning device and the portion of the cleaning target such that a part of a cleaning guide between the cleaning device and the portion of the cleaning target is operational to guide the cleaning flow to the portion of the cleaning target.

Clause 14: The charged particle assessment system of clause 13, wherein the sample holder or guide holder is configured to be displaceable in a downbeam direction during operation of the cleaning device.

Clause 15: The charged particle assessment system of any of clauses 10 to 14, wherein the cleaning guide comprises a guide part that is disposed downbeam of the optical system.

Clause 16: The charged particle assessment system of clause 15, wherein the sample holder comprises a holding surface configured to hold the sample, preferably the holding surface is recessed into the sample holder.

Clause 17: The charged particle assessment system of clause 16, wherein the guide part is disposed at a position between 2 mm and 50 mm, desirably between 5 mm and 15 mm, downbeam of the sample holder, preferably of the holding surface.

Clause 18: The charged particle assessment system of any of clauses 15 to 17 wherein the guide part comprises a deflector having a deflector surface configured to deflect the cleaning flow upbeam towards the portion of the cleaning target.

Clause 19: The charged particle assessment system of clause 18, wherein the deflector surface is disposed such that the cleaning flow from the cleaning device is directed so that it is incident on the cleaning target.

Clause 20: The charged particle assessment system of clause 18 or 19, wherein the deflector surface is shaped and positioned relative to the at least the portion of the cleaning target to deflect, preferably focus, the cleaning flow towards the at least the portion of the cleaning target.

Clause 21: The charged particle assessment system of clause 20, wherein the deflector surface is curved.

Clause 22: The charged particle assessment system of clause 20 or 21, wherein the deflector surface comprises a Fresnel lens, preferably the deflector surface has a topography that functions as a Fresnel lens, preferably so as to focus the cleaning flow along the cleaning path towards the cleaning target.

Clause 23: The charged particle assessment system of clause 20, wherein the deflector surface is planar.

Clause 24: The charged particle assessment system of clause 15 to 23, wherein the cleaning guide comprises a guidance tube to direct the cleaning flow along at least part of a path, such as a cleaning path of the cleaning flow from the cleaning device to the cleaning target.

Clause 25: The charged particle assessment system of clause 24, wherein the guidance tube extends upbeam towards the cleaning target, preferably from a support, preferably the support is the sample holder or the guide holder.

Clause 26: The charged particle assessment system of clause 24 or 25, wherein the guidance tube extends downbeam from the cleaning device, preferably the guidance tube is directed towards the sample holder or guide holder, preferably to guide the cleaning flow towards the deflector preferably the deflector being positioned to deflect the cleaning flow towards the at least the portion of the target position.

Clause 27: The charged particle assessment system of any preceding clause, further comprising a charged particle source configured to project the beam of charged particles towards the sample, preferably the charged particle source comprising in part the cleaning device, so that on operation of the charged particle source, the charged particle beam is configured to stimulate the cleaning medium at or near the cleaning target such that the cleaning medium cleans at least a portion of the cleaning target.

Clause 28: The charged particle assessment system of clause 27, wherein the cleaning device operates to clean the portion of the cleaning target during operation of the charged particle assessment tool.

Clause 29: The charged particle assessment system of clause 27 or 28, the charged particle system comprising an electron-optical arrangement comprising the cleaning target, wherein the sample holder and the charged particle device are controlled during operation of the charged particle source such that the path of the charged particle beam is reflected from the sample, the sample holder or both upbeam onto at least the clean target.

Clause 30: The charged particle assessment system of any preceding clause further comprising a heat source configured to stimulate the cleaning medium at or near the cleaning target such that the cleaning medium cleans at least a portion of the cleaning target, preferably the heat source is configured to apply a heat load to the cleaning target.

Clause 31: The charged particle assessment system of any preceding clause, further comprising a light emitter configured to emit stimulating light having a wavelength that stimulates the cleaning medium to clean at least a portion of the cleaning target, preferably the light stimulates the cleaning medium at or near the cleaning target..

Clause 32: The charged particle assessment system of clause 30 further comprising a light guide configured to direct stimulating light along a light path from a light emitter to the portion of the cleaning target.

Clause 33: The charged particle assessment system of clause 32, wherein the light emitter is disposed upbeam of the cleaning target, preferably the cleaning target is a detector within the charged particle optical system.

Clause 34: The charged particle assessment system of clause 31 or 32, wherein the light guide is disposed downbeam of the charged particle optical system.

Clause 35: The charged particle assessment system of any of clauses 31 to 34, wherein the light guide comprises a reflector configured to reflect the stimulating light.

Clause 36: The charged particle assessment system of clause 35 wherein sample holder comprises a holding surface configured to hold the sample, preferably the holding surface is recessed into the sample holder, and preferably the reflector is disposed at a position between 5 mm and 15 mm downbeam of the holding surface.

Clause 37: The charged particle assessment system of clause 35 or 36, wherein the reflector comprises a reflector surface that is shaped and positioned relative to the at least the portion of the cleaning target to reflect, preferably focus, the stimulating light towards the at least the portion of the cleaning target.

Clause 38: The charged particle assessment system of clause 37, wherein the reflector surface is curved.

Clause 39: The charged particle assessment system of clause 37 or 38, wherein the reflector surface comprises a Fresnel lens.

Clause 40: The charged particle assessment system of clause 37, wherein the reflector surface is planar.

Clause 41: The charged particle assessment system of any of clauses 35 to 40, wherein the reflector is comprised in a guide part configured to guide the cleaning flow along part of a cleaning path from a cleaning device towards the cleaning target, the guide part preferably comprising a deflector for directing the fluid flow towards the cleaning target.

Clause 42: The charged particle assessment system of any of clauses 30 to 40, wherein at least a part of the light emitter is comprised in the cleaning device and is preferably a plasma generator configured to generate plasma for providing the cleaning medium and light for example having an UV wavelength.

Clause 43: The charged particle assessment system of any of clauses 31 to 42, wherein at least a part of the light emitter is separate from the cleaning device, preferably the light emitter is associated with the cleaning device so that a light path from the emitter is substantially similar to the cleaning path from the cleaning device to the target, preferably the light emitter is positioned downbeam of the cleaning target, for example comprised in or associated with the sample holder.

Clause 44: The charged particle assessment system of any of clauses 31 to 43, wherein at least part of the cleaning guide is transparent to stimulating light and is disposed between the light emitter and the reflector.

Clause 45: The charged particle assessment system of clause 44, wherein the reflector comprises an outer surface configured to reflect stimulating light, and wherein the cleaning guide is disposed on the outer surface of the reflector.

Clause 46: The charged particle assessment system of any of clauses 31 to 45, wherein the light emitter is a UV emitter.

Clause 47: The charged particle assessment system of any of clauses 35 to 46, further comprising a guide holder configured to support the reflector.

Clause 48: The charged particle assessment system of clauses 11 to 14 or 47, wherein the guide holder is configured to be movable.

Clause 49: The charged particle assessment system of clause 47 or 48, wherein the reflector is disposed in the sample holder, the sample holder preferably comprising a stage.

Clause 50: The charged particle assessment system of any of clauses 47 to 49, wherein the sample holder or guide holder is configured to be positioned relative to the cleaning device and the portion of the cleaning target such that any part of a cleaning guide therebetween is operational to reflect the stimulating light to the portion of the cleaning target.

Clause 51: The charged particle assessment system of any preceding clause, wherein the cleaning device comprises a cleaning guide and/or a light emitter that are disposed downbeam of the optical system.

Clause 52: The charged particle assessment system of any preceding clause, further comprising a cleaning device holder configured to support the cleaning device and/or the light emitter.

Clause 53: The charged particle assessment system of clause 52, wherein the cleaning device holder is configured to be movable, preferably in the direction of the beam path.

Clause 54: The charged particle assessment system of clause 52, wherein the cleaning source and/or the light emitter are disposed in the cleaning device holder, the cleaning device holder may comprise a stage.

Clause 55: The charged particle assessment system of any of the preceding clauses, wherein at least part of the charged particle optical system is disposed in a vacuum chamber and the cleaning device, e.g. cleaning source, and/or the light emitter, e.g. UV light source, is separated from the vacuum chamber by a separating flange.

Clause 56: The charged particle assessment system of any preceding clause, wherein at least part of the charged particle optical system is disposed in a vacuum chamber and the cleaning device, e.g. cleaning source and/or the light emitter, is disposed in the vacuum chamber.

Clause 57: The charged particle assessment system of any preceding clause wherein a component or feature of the charged particle assessment system configured to guide and/or direct the cleaning flow from the cleaning device to the cleaning target comprises a material resilient and durable to exposure to the cleaning medium, for example quartz, preferably such components may be at least one of the reflector, and a component of a the cleaning guide such as a deflector and the guidance tube, preferably the charged particle assessment system comprises a cleaning arrangement comprising the cleaning device and at least one of the reflector, deflector and guidance tube.

Clause 58: A method of operating a charged particle assessment system configured to project a beam of charged particles towards a sample, the charged particle assessment system comprising: a sample holder configured to hold a sample, a charged particle optical system configured to project a beam of charged particles from a charged particle source downbeam towards the sample; the charged particle optical system comprising a cleaning target, the method comprising: 1) supplying a cleaning medium in a cleaning flow towards the cleaning target incident on the cleaning target, the suppling of the cleaning flow such that cleaning flow approaches the cleaning target from downbeam of the cleaning target; and 2) stimulating the cleaning medium at or near the cleaning target such that the cleaning medium cleans at least a portion of the surface of the cleaning target.

Clause 59: The method of clause 58, wherein the supplying of the cleaning medium is by a cleaning device.

Clause 60: The method of clause 58 or 59, wherein the stimulating is by operation of a charged particle source of the charged particle assessment system, the charged particle source projecting a beam of charged particles at or near the cleaning target such that the cleaning medium cleans at least a portion of the surface of the cleaning target.

Clause 61: The method of any of clauses 58 to 60, wherein the stimulating is by directing stimulating light from a light emitter at or near the cleaning target such that the cleaning medium cleans at least a portion of the surface of the cleaning target.

Clause 62: The method of any of clauses 58 to 61, wherein the cleaning flow towards the cleaning target is along a cleaning path from a position downbeam of the optical system to the cleaning target, preferably the portion of the surface of the cleaning target.

Clause 63: A charged particle assessment system for projecting a beam of charged particles towards a sample, the system comprising: a sample holder configured to hold a sample; a charged particle optical system configured to project a beam of charged particles from a charged particle source downbeam towards the sample; the charged particle optical system comprising a cleaning target, and a cleaning arrangement comprising: a cleaning device to supply cleaning medium in a cleaning flow; a cleaning guide configured to guide and direct the cleaning flow from the cleaning device a towards the cleaning target so the cleaning flow is incident on the cleaning target so that cleaning flow approaches the cleaning target from downbeam of the cleaning target, wherein the cleaning device is positioned in an up-beam direction relative to the sample holder and the cleaning guide comprises a flow deflector configured to deflect the cleaning flow towards the cleaning target.

Clause 64: The charged particle assessment system of clause 63, wherein the flow deflector is positioned in a downbeam direction of the cleaning target at least during a cleaning operation.

Clause 65: The charged particle assessment system of clause 63 or 64, wherein the flow deflector is comprised in a support, the support being a stage comprising the sample holder or a guide stage separate from the stage comprising the sample holder.

Clause 66: The charged particle assessment system of clause 63, 64, or 65, wherein the cleaning arrangement is configured to stimulate the cleaning medium at or near the cleaning target such that the cleaning fluid cleaning medium cleans at least a portion of the surface of the cleaning target.

Clause 67: The charged particle assessment system of any of clauses 63 to 66, wherein the cleaning arrangement further comprises a light emitter configured to stimulate the cleaning medium.

Reference to a component or system of components or elements being controllable to manipulate a charged particle beam in a certain manner includes configuring a controller or control system or control unit to control the component to manipulate the charged particle beam in the manner described, as well optionally using other controllers or devices (e.g. voltage supplies and or current supplies) to control the component to manipulate the charged particle beam in this manner. For example, a voltage supply may be electrically connected to one or more components to apply potentials to the components, such as in a non-limited list the control lens array 250, the objective lens array 241, the condenser lens 231, correctors, a collimator element array and scan deflector array 260, under the control of the controller or control system or control unit. An actuatable component, such as a stage, may be controllable to actuate and thus move relative to another components such as the beam path using one or more controllers, control systems, or control units to control the actuation of the component.

The embodiments herein described may take the form of a series of aperture arrays or electron-optical elements arranged in arrays along a beam or a multi-beam path. Such electron-optical elements may be electrostatic. In an embodiment all the electron-optical elements, for example from a beam limiting aperture array to a last electron-optical element in a sub-beam path before a sample, may be electrostatic and/or may be in the form of an aperture array or a plate array. In some arrangements one or more of the electron-optical elements are manufactured as a microelectromechanical system (MEMS) (i.e. using MEMS manufacturing techniques).

References to upper and lower, up and down, above and below should be understood as referring to directions parallel to the (typically but not always vertical) upbeam and downbeam directions of the electron beam or multi-beam impinging on the sample 208. Thus, references to upbeam and downbeam are intended to refer to directions in respect of the beam path independently of any present gravitational field.

An assessment system according to an embodiment of the disclosure may be a tool which makes a qualitative assessment of a sample (e.g. pass/fail), one which makes a quantitative measurement (e.g. the size of a feature) of a sample or one which generates an image of map of a sample. Examples of assessment systems are inspection tools (e.g. for identifying defects), review tools (e.g. for classifying defects) and metrology tools, or tools capable of performing any combination of assessment functionalities associated with inspection tools, review tools, or metrology tools (e.g. metro-inspection tools). The electron-optical column 40 may be a component of an assessment system; such as an inspection tool or a metro-inspection tool, or part of an e-beam lithography tool. Any reference to a tool herein is intended to encompass a device, apparatus or system, the tool comprising various components which may or may not be collocated, and which may even be located in separate rooms, especially for example for data processing elements.

The terms "sub-beam" and "beamlet" are used interchangeably herein and are both understood to encompass any radiation beam derived from a parent radiation beam by dividing or splitting the parent radiation beam. The term "manipulator" is used to encompass any element which affects the path of a sub-beam or beamlet, such as a lens or deflector.

References to elements being aligned along a beam path or sub-beam path are understood to mean that the respective elements are positioned along the beam path or sub-beam path.

While the present invention has been described in connection with various embodiments, other embodiments of the invention will be apparent to those skilled in the art from consideration of the specification and practice of the invention disclosed herein. It is intended that the specification and examples be considered as exemplary only, with a true scope and spirit of the invention being indicated by the following claims and clauses disclosed herein.

The descriptions above are intended to be illustrative, not limiting. Thus, it will be apparent to one skilled in the art that modifications may be made as described without departing from the scope of the claims set out below and the clauses set out herein.

## Claims

1. A charged particle assessment system for projecting a beam of charged particles towards a sample, the system comprising:
a sample holder configured to hold a sample;
a charged particle optical system configured to project a beam of charged particles from a charged particle source downbeam towards the sample and comprising a cleaning target; and
a cleaning device configured: to supply cleaning medium in a cleaning flow towards the cleaning target incident on the cleaning target so that the cleaning flow approaches the cleaning target from downbeam of the cleaning target, and to stimulate the cleaning medium at or near the cleaning target such that the cleaning medium cleans at least a portion of the surface of the cleaning target.

2. The charged particle assessment system of claim 1, wherein at least part of the cleaning target is positioned proximate to the sample.

3. The charged particle assessment system of claim 1 or claim 2, wherein the cleaning device comprises a cleaning guide configured to direct the cleaning flow to the cleaning target.

4. The charged particle assessment system of claim 3, wherein the at least part of the cleaning guide is disposed in the support, preferably wherein the support is a stage.

5. The charged particle assessment system of claim 3 or 4, wherein the cleaning guide comprises a guide part that is disposed downbeam of the optical system.

6. The charged particle assessment system of claim 5, wherein the guide part comprises a deflector having a deflector surface configured to deflect the cleaning flow upbeam towards the portion of the cleaning target.

7. The charged particle assessment system of claim 6, wherein the deflector surface is shaped and positioned relative to the at least the portion of the cleaning target to deflect the cleaning flow towards the at least the portion of the cleaning target.

8. The charged particle assessment system of claim 5 to 7, wherein the cleaning guide comprises a guidance tube to direct the cleaning flow along at least part of a path of the cleaning flow from the cleaning device to the cleaning target.

9. The charged particle assessment system of any preceding claim, further comprising a light emitter configured to emit stimulating light having a wavelength that stimulates the cleaning medium to clean at least a portion of the cleaning target.

10. The charged particle assessment system of claim 9, further comprising a light guide configured to direct stimulating light along a light path from the light emitter to the portion of the cleaning target.

11. The charged particle assessment system of claim 10, wherein the light guide comprises a reflector configured to reflect the stimulating light.

12. The charged particle assessment system of any preceding claim, wherein the charged particle optical system comprises a plurality of electron-optical elements, and the cleaning target comprises one of the plurality of electron-optical elements.

13. The charged particle assessment system of claim 12, wherein
the plurality of electron-optical elements comprises an objective lens arrangement, configured to focus the beam of charged particles on the sample; and
the cleaning target comprises the objective lens.

14. The charged particle assessment system of claim 12 or 13, wherein the electron-optical elements comprises a detector configured to detect signal particles emitted from the sample in response to the beam of charged particles.

15. The charged particle assessment system of claim 14, wherein the cleaning device is disposed upbeam of the detector.
